(19) Europäisches Patentamt
European Patent Office
Office européen des brevets

(11) **EP 1 221 663 B1**

(12) **EUROPEAN PATENT SPECIFICATION**

(45) Date of publication and mention
of the grant of the patent:
**24.06.2009 Bulletin 2009/26**

(51) Int Cl.:
***G06F 17/50*** *(2006.01)*

(21) Application number: **01108653.5**

(22) Date of filing: **05.04.2001**

(54) **A method of circuit verification in digital design**

Verfahren zur Prüfung von Schaltungen in dem digitalen Entwurf

Méthode pour la vérification de circuits dans la conception digitale

(84) Designated Contracting States:
**DE FR GB IT NL**

(30) Priority: **08.01.2001 DE 10100433**

(43) Date of publication of application:
**10.07.2002 Bulletin 2002/28**

(73) Proprietor: **Onespin Solutions GmbH**
**80339 München (DE)**

(72) Inventor: **Johannsen, Peer**
**80939 München (DE)**

(74) Representative: **Hofmann, Harald et al**
**Sonnenberg Fortmann,**
**Patent- & Rechtsanwälte,**
**Postfach 33 08 65**
**80331 München (DE)**

(56) References cited:
**US-A- 5 465 216**      **US-A- 5 926 622**

• **WONG W: "Modelling bit vectors in HOL: the word library" HIGHER ORDER LOGIC THEOREM PROVING AND ITS APPLICATIONS. 6TH INTERNATIONAL WORKSHOP, HUG '93 PROCEEDINGS SPRINGER-VERLAG BERLIN, GERMANY, 1994, pages 372-384, XP008059297 ISBN: 3-540-57826-9**
• **HUANG CHUNG-YANG ET AL: "Assertion checking by combined word-level ATPG and modular arithmetic constraint-solving techniques" PROC DES AUTOM CONF; PROCEEDINGS - DESIGN AUTOMATION CONFERENCE 2000 IEEE, PISCATAWAY, NJ, USA, 2000, pages 118-123, XP002365707**
• **KAVVADIAS D ET AL: "The inverse satisfiability problem" SIAM JOURNAL ON COMPUTING SIAM USA, vol. 28, no. 1, 1998, pages 152-163, XP008059300 ISSN: 0097-5397**

**Description**

Field of the invention

The present invention relates to a method of circuit verification in digital design and in particular relates to a method of register transfer level property checking to enable the same.

Background to the invention

Today's electrical circuit designs frequently contain up to several million transistors and circuit designs need to be checked to ensure that circuits operate correctly. Formal methods for verification are becoming increasingly attractive since they confirm design behaviour without exhaustively simulating a design. Over the past years, bounded model checking and bounded property checking have increased in significance in electronic design automation (EDA). When checking large industrial circuits, long run times, ranging between hours and several days, are quite common. With designs continually increasing in size and complexity the test for correct behaviour becomes more important and a major economic issue, but at the same time becomes more complex, time consuming and expensive. Automated abstraction techniques have been developed to enhance capabilities of formal verification methods.
Abstraction techniques are used as a pre-process in high-level property checking of digital circuits. The majority of today's industrial hardware verification tools use bit-level decision procedures, like decision procedures for the Boolean satisfiability problem (SAT) or decision procedures based on binary decision diagrams (BDDs). In electronic design automation, SAT procedures have many direct applications, including test pattern generation, timing analysis, logic verification, functional testing, etc. SAT belongs to the class of NP-complete problems, with algorithmic solutions having exponential worst case complexity. This problem has been widely investigated and continues to be so because efficient SAT techniques can greatly affect the operation of many EDA tools. For example in VLSI CAD, SAT formulations start from an abstract circuit description, for which a required output value needs to be validated. The resulting formulation is then mapped on to an instance of SAT. Conjunctive Normal Form (CNF) formulae can be used and several versions of this procedure incorporate a chronological backtrack-determination: at each node in the search tree, an assignment is selected and a subsequent search procedure is controlled by iterative application of "unit clauses" and "pure literal rules". Non-chronological backtrack determinations are also known. An alternative to SAT are BDDs: a set of BDD's can be constructed representing output value constraints. The conjunction of all the constraints expressed as a Boolean product of the corresponding BDD (termed as a product BDD) represents the set of all satisfying solutions. Any element of the resulting constraint set gives a feasible SAT solution. However a major limitation of this approach is that there is a corresponding exponential increase in memory requirement for the operating system and in run times of the verification tools. The CNF-based SAT solvers can be directly applied to circuits, which are broken down into bit-level Boolean logic, by transforming the entire circuit into CNF formulae. However, since practical gate-level circuit descriptions can be quite large, dealing with substantially large CNF formulae results in unacceptable CPU run times. However, circuit designs are usually defined in terms of Register-Transfer-Level (RTL) specifications, for example, coded in hardware description languages (HDL's) like VHDL or Verilog. RTL specifications of digital circuits contain explicit structural information which is lost in bit-level descriptions. At the bit-level, for example in gate lists, all signals are of 1-bit width and all available functional units are Boolean gates. In contrast, with RTL, word-level data structures, for example bit-vectors and buses, as well as high-level operators, for example adders, multipliers and shifters, are still visible. Several approaches to formal circuit verification have been proposed which make use of such high level information.
D. Cyrluk et al present a word-level decision procedure for the core theory of bit-vectors with extraction and concatenation in "An efficient decision procedure for the theory of fixed sized bit-vectors" (CAV-97), pages 60 to 71, 1997, using bit-vector BDDs and applying width abstraction to the core theory.
Document US 5,946,481 describes a method and a device for forming a restricted model from a system model for formally verifying the system and design. The method of US 5,946,481 1 its based on eliminating system model variables and system model inputs that are not used for a function of the system model state. In this case, a restricted model is a system model which is restricted to certain state transitions, limited by restricting the variables of the system model.
Document US 5,465,216 discloses a method and an apparatus for formal verification. A state transition system with corresponding specifications is reduced and subsequently verified by formal verification such as simple model verification. US 5,465,216 describes the parameterization of values within the full model for reducing the number of states and thereby the model of the circuit. Subsequently, an HDL description may be generated.
Document US 5,926,622 discloses a method and an apparatus for verifying the behaviour of properties or functions of a system for running a simulation on a reduced model for verifying the behaviour of properties of the system. The concept of US 5,926,622 is based on running a simulation of the system.

EP 1 221 663 B1

Object of the invention

The present invention seeks to provide an improved circuit verification procedure.

Statement of the invention

In accordance with a first aspect of the invention, there is provided a digital circuit design verification method comprising: automatically determining for each property of a non reduced RTL model a reduced RTL model with reduced signal width for a design specification, which reduced RTL model retains the signal property of the non-reduced RTL model, wherein the RTL model includes word-level signals comprising bit-vectors and, for each bit-vector variable, the method of reducing the RTL model is separated into two sequential steps; the first step comprising the computation of the coarsest granularity of each word-level signal whereby to separate each signal into several contiguous chunks which indicate the basic groups of bits with respect to structural data dependencies, the second step comprising the computation of the minimum width with respect to dynamic data dependencies; and subjecting the reduced RTL model to a property checking process. The design verification process comprises, in a step prior to the determination of a reduced width RTL model, of determining the design specification of the digital circuit design and the specification of the properties to be investigated, synthesising an RTL netlist of high level primitives whereby the circuit is defined as an interconnection of control and data path portions, wherein in signals of a width *n* are determined such that:

$$n \in \mathbb{N}_+;$$

wherein bitvectors of respective length determine the signal value. Conveniently, in the property checking process, an internal bit level representation contains a bit level variable for each bit of each word signal. This bit-level representation is passed to a verification engine and then to a property test unit which operates to provide a positive result if the investigated property holds true for the circuit and which operates to provide a counter-example if the property does not hold. In the event that a counter-example is produced for the reduced RTL design, signal width enhancement is performed to create a counter-example for the original RTL.

In accordance with a further aspect of the present invention there is provided a digital circuit design verification tool wherein a pre-property checking unit is operable to reduce the widths of the signals occurring in an RTL model of an input design specification and an input property specification to determine a reduced width RTL model, wherein the RTL model includes word-level signals comprising bit-vectors and, for each bit-vector variable, the tool is operable to reduce the RTL model width of a signal in two sequential steps; wherein, a first step, a coarse granularisation of each word-level signal is determined whereby to separate each signal into several contiguous chunks which indicate the basic groups of bits with respect to structural data dependencies; and, in a second step, a minimum width with respect to dynamic data dependencies is determined;, which reduced width RTL model retains the specific signal property of a non-reduced RTL model. The tool further comprises a front end unit operable to receive input data relating to a design specification and the property characteristics of a design to be verified and is operable to provide an RTL netlist of the circuit design and property whereby the circuit can be defined as an interconnection of control and data path portions, wherein in signals of a width n are determined such that $n \in \mathbb{N}_+;$ and bitvectors of a respective length determine the signal value. Conveniently a property checking unit is operable to create an internal bit level representation having received a reduced RTL representation. This representation is sequentially passed to a verification engine and to a property test unit. The property test unit being operable to provide a positive result if the circuit property holds true and which is operable to provide a counter-example in the case of the property does not hold. Conveniently the signal width enhancement unit is operable to receive counter-examples for reduced RTL data and to expand the signal width to provide a counter example for the original RTL.

A linear signal width reduction causes an exponential reduction of the induced state space. Reducing state space sizes in general goes hand in hand with reduced verification runtimes. Thus the technique holds a high potential for speeding up verification tasks. Tests have shown that the present invention can significantly reduce the runtimes of existing prover tools. Furthermore, the present invention will be able to process design sizes which have, hitherto, exceeded the capacities of existing verification tools and which could not be taken into account before due to resource limitations. FIFO's, queues, stacks, bridges and interface protocols comprise part of a class of digital hardware designs to which the present invention is particularly well suited to processing.

A further advantage of the present invention is that, if the analysis yields that no reduction at all is possible for a given design and a given property, then reduced model and original design are identical. The verification task itself cannot be impaired by using the proposed method as a pre-process, and in all case studies pre-processing runtimes were negligible Furthermore, the technique can be applied in high-level equivalence checking and high-level simulation. High-level equivalence checking, for example, can be considered a special case of high-level property checking. The design specification can include two different implementations of the same circuit and the property can require functional equivalence, or the property itself can be written in a hardware description language representing a functional specification of the circuit.

Brief description of the figures

The invention may be understood more readily, and various other aspects and features of the invention may become apparent, from consideration of the following description and the figures as shown in the accompanying drawing sheets, wherein:

Figures 1a and 1b show property checking flow diagrams;
Figure 2 shows the basic steps involved in the abstraction technique of this invention;
Figure 3 is a table detailing the syntax of various bit-vector operators supported in the reduction technique of this invention;
Figure 4 is a flow chart detailing the generation of the reduced RTL model;
Figure 5 shows the effect of slicing equivalence classes;
Figure 6 illustrates a granularity analysis in terms of bit-vectors, dependency classes of bit-vector chunks and granularities; and
Figure 6a details a process for determining the granularity analysis of bit-vector equations;
Figure 7 illustrates a minimum width computation for a dependency class;
Figure 7a details a process for reduced model generation;
Figure 8 shows a block diagram of an Asynchronous Transfer Mode (ATM) switching element operable in accordance with the invention;
Figure 9 comprises tabulated results of the address management unit shown in Figure 8;
Figure 10 shows a granularity analysis flow chart together with a first example;
Figure 11 shows a granularity analysis flow chart together with a second example;
Figure 12 shows a granularity analysis flow chart together with a third example;
Figure 13 shows a minimal width abstraction flow chart together with a first example;
Figure 14 shows a minimal width abstraction flow chart together with a second example;
Figure 15 shows a minimal width abstraction flow chart together with a third example;
Figure 16 shows a model generation flow chart together with a first example;
Figure 17 shows a model generation flow chart together with a second example; and
Figure 18 shows a model generation flow chart together with a third example.

Detailed description of invention

There will now be described by way of example, the best mode contemplated by the inventor for carrying out the invention. In the following description numerous specific details are set out in order to provide a complete understanding of the invention. It will be apparent however, to those skilled in the art, that the present invention may be put in to practice with variations of the specific.

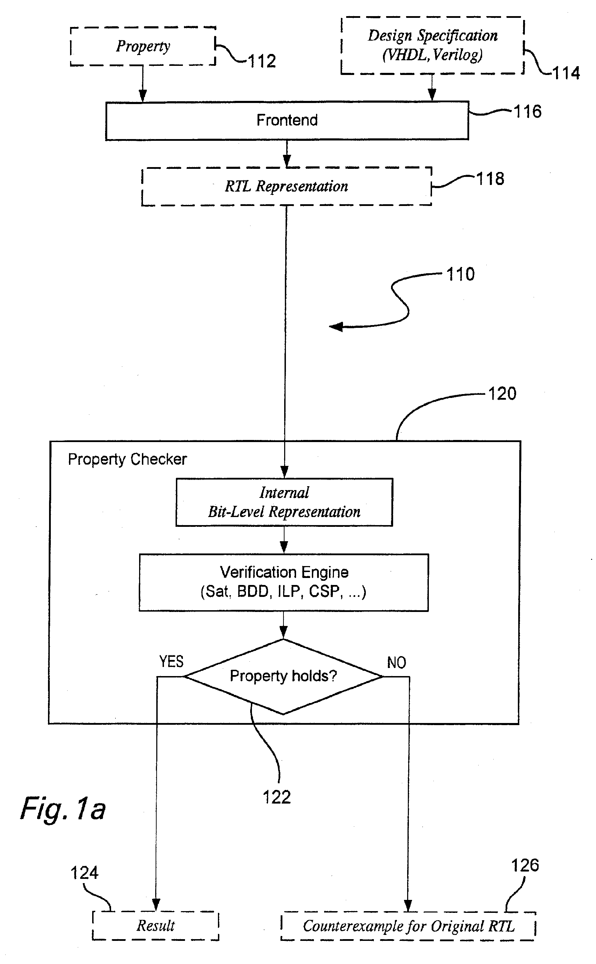

Referring to Figure 1a there is shown a prior-art property checking flow diagram. A property specification, 112, and a design specification, 114, is presented to a bounded property checker, 120. The property and design specifications, 112, 114, are input to a front end processor which converts the specifications to Register Transfer Level (RTL) specifications. A decision relating to the property is made at decision point 122: if the property holds then the design feature is confirmed 124; if the property does not hold, then a counterexample 126 is determined. A counterexample, as is known, is an indication that a circuit does not function in the way intended by the designer; a counterexample is given in terms of assignments of values to the circuit inputs such that a violation of the desired behaviour which is described by the property specification can be observed when looking a the values of the circuit outputs resulting from the circuit inputs. A design modification would be made to eliminate the occurrence of the counterexample and, indeed, further counterexamples which may consequentially arise.

The present invention employs the use of properties described in a linear time logic over finite bounded intervals of time. Properties consist of an assumption part which implies a commitment part:

$$Property \quad \equiv \quad Assumptions \implies Commitment$$

Properties specify the intended behaviour of the design within a finite interval of time and consist of temporal operators and state expressions, involving relationships among data words. As an example consider:

    assume (during [t+0, t+4]: reset = 0) and (at t+0: request = 1);
    prove (at t+3: acknowledge = 1) and (at t+4: data = 11111111);

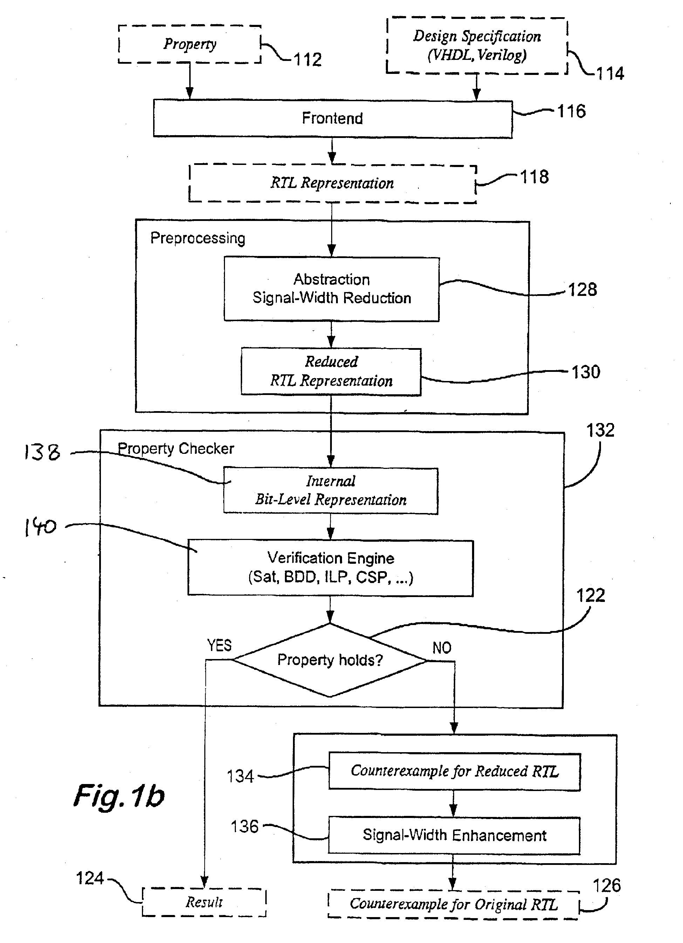

Referring now to Figure 1b, there is shown a property-checking flow in accordance with the invention. As a first step, design and property are synthesized into a flattened netlist of high-level primitives, called an RTL netlist, as is known. These netlists include word-level signals, word-level gates, arithmetic units, comparators (data to control), multiplexors (control to data) and memory elements Each signal $x$ has a fixed given width $n \in \mathbb{N}_+$ and takes bitvectors of respective length as values. The RTL representation of the design is handed to a property checker which translates the netlist into a bit-level representation and either proves that the property holds for the given design, or returns a counterexample.

In a pre-processing step prior to the invocation of the property checker, the RTL netlist is obtained, 118, and a scaled down RTL model 130 is computed by signal-width reduction processor, 128, in which signal widths are reduced, while guaranteeing that:

$$\text{The property holds for the original RTL} \iff \text{The property holds for the reduced RTL}$$

The reduced RTL, 130, is given to the property checker, 132, instead of the original RTL. The internal bit-level representation, 138, used by the property checker contains a bit-level variable for each bit of each word-level signal of the RTL representation, and, depending on the degree of reduction of the signal widths, now can contain significantly less variables for the reduced RTL. The property checker, 132 includes a verification engine (SAT, BDD...), 140. If the property does not hold, the property checker returns a counterexample in terms of an assignment of values to all inputs of the reduced RTL, 134. The method provides a technique which takes such counterexample and generates an assignment of values to the inputs of the original design in a signal width enhancement step by signal width enhancement processor, 136, such that the property does not hold when these input values are applied to the circuit, and provides a counterexample, 126.

The invention conveniently uses structural data-path dependency analyses for minimum width abstractions. The basic idea is illustrated by the following introductory examples.

In a first example, example 1, we assume we want to check if the conjunction of two word-level signals of width 8, denoted by $x[8]$ and $y[8]$ can evaluate to the 8-bit zero vector. Let 'and' denote bitwise Boolean conjunction. In RTL, we have to check if the equation

$$x_{[8]} \text{ and } y_{[8]} \quad = \quad 00000000 \qquad (1)$$

is satisfiable. A corresponding bit-level representation of the same problem involves 16 variables and 8 equations. It is not necessary to solve all 8 equations because bit positions 0-7 are treated uniformly. Let $x'_{[1]}$ and $y'_{[1]}$ denote signals of width 1. It is sufficient to check if:

$$x'_{[1]} \text{ and } y'_{[1]} \quad = \quad 0 \qquad (2)$$

is satisfiable, because (1) is satisfiable if and only if (2) is satisfiable. Furthermore, a satisfying solution for (1) can be obtained from a satisfying solution of (2) by copying the values of $x'_{[1]}$ 1 and $y'_{[1]}$ into all bit positions of the corresponding signals of (1). For example, $x'_{[1]} = 1$, yields $x_{[8]} = 00000000$ and $y_{[8]} = 11111111$.

In the example above, signals $x_{[8]}$ and $y_{[8]}$ both could be reduced to a width of one bit. In general, reduction depends on the structural data dependencies occurring in the cone of influence of a signal in a given design.

In a second example, given the assumptions of Example 1, we let $z_{[4]}$ be an additional word-level signal of width 4 and assume that $z_{[4]}$ is assigned to the 4 most significant bits of $x_{[8]}$. That is to say we have to check if the following system of equations is satisfiable:

$$x_{[8]}[7,4] \quad = \quad z_{[4]}$$
$$x_{[8]} \text{ and } y_{[8]} \quad = \quad 00000000 \tag{3}$$

Bit positions 0-3 as well as 4-7 are treated uniformly, though both cases in a different way. Signals $x_{[8]}$ and $y_{[8]}$ have to be split. Let $x^1_{[2]}$, $y^1_{[2]}$ and $z^1_{[1]}$ denote signals of width 2 and 1 respectively, and consider:

$$x^1_{[2]}[1,1] \quad = \quad z^1_{[1]} \tag{4}$$
$$x^1_{[2]} \text{ and } y_{[2]} \quad = \quad 00$$

System (3) is satisfiable if and only if (4) is satisfiable. To obtain a solution of (3), we copy $x'_{[2]}[1, 1]$ into all positions of $x_{[8]}[7, 4]$ and $x'_{[2]}[0, 0]$ into all positions of $x_{[8]}[3, 0]$. The same is done for $y'_{[2]}$ and $y_{[8]}$, and $z'_{[1]}$ is copied into all positions of $z_{[4]}$. For example, $x'_{[2]} = 10$, $y'_{[2]} = 01$, $z'_{[1]} = 1$, yields $x_{[8]} = 11110000$, $y_{[8]} = 00001111$ and $z_{[4]} = 1111$.

Signals $x_{[8]}$ and $y_{[8]}$ are both split into two parts, and each part can be reduced to a width of one bit, resulting in an overall width of 2 bits for $x'_{[2]}$ and $y'_{[2]}$. In general, it is not always possible to reduce a chunk of bits processed in exactly the same manner to only one bit. Equations containing dynamic data dependencies, e.g. if-then-else operators, require an analysis of all possible inequalities between signals, as shown in the following example.

In a third example, we let $x_{[8]}$, $y_{[8]}$ and $z_{[8]}$ be data signals of width 8, and let $\mathbf{a}_{[1]}$, $\mathbf{b}_{[1]}$ and $\mathbf{c}_{[1]}$ be control signals. The satisfiability of the following system of equations can be characterised as:

$$
\begin{aligned}
\mathbf{a}_{[1]} &= \text{ite}(x_{[8]} = y_{[8]},\ 0_{[1]},\ 1_{[1]}) \\
\mathbf{b}_{[1]} &= \text{ite}(y_{[8]} = z_{[8]},\ 0_{[1]},\ 1_{[1]}) \quad\quad \textit{satisfiable} \\
\mathbf{c}_{[1]} &= \text{ite}(z_{[8]} = x_{[8]},\ 0_{[1]},\ 1_{[1]}) \quad\quad \Leftrightarrow \quad x_{[8]} \neq y_{[8]} \wedge y_{[8]} \neq z_{[8]} \wedge z_{[8]} \neq x_{[8]} \\
1_{[1]} &= \mathbf{a}_{[1]} \text{ and } \mathbf{b}_{[1]} \text{ and } \mathbf{c}_{[1]}
\end{aligned}
$$

Obviously, $x_{[8]}$, $y_{[8]}$ and $z_{[8]}$ cannot be reduced to a width of only one bit, because $x_{[8]} \neq y_{[8]} \wedge y_{[8]} \neq z_{[8]} \wedge z_{[8]} \neq x_{[8]}$ is satisfiable, while $x'_{[1]} \# y'_{[1]} \wedge y'_{[1]} \neq z'_{[1]} \wedge z'_{[1]} \neq x'_{[1]}$ is not. Insted the following holds:

Instead, the following holds:

$x_{[m]} \neq y_{[m]} \wedge y_{[m]} \neq z_{[m]} \wedge z_{[m]} \neq x_{[m]}$ is satisfiable for all $m \geq 2$.
Therefore, 2 is the minimum value for $m$ which

$$x_{[8]} \neq y_{[8]} \wedge y_{[8]} \neq z_{[8]} \wedge z_{[8]} \neq x_{[8]} \quad \overset{\textit{satisfiable}}{\Leftrightarrow} \quad x_{[m]} \neq y_{[m]} \wedge y_{[m]} \neq z_{[m]} \wedge z_{[m]} \neq x_{[m]}$$

is true, and thus the original system of equations can be replaced by

$\mathbf{a'}_{[1]} = \text{ite}(\mathbf{x'}_{[2]}=\mathbf{y'}_{[2]}, 0_{[1]}, 1_{[1]})$
$\mathbf{b'}_{[1]} = \text{ite}(\mathbf{y'}_{[2]}=\mathbf{z'}_{[2]}, 0_{[1]}, 1_{[1]})$
$\mathbf{c'}_{[1]} = \text{ite}(\mathbf{z'}_{[2]}=\mathbf{x'}_{[2]}, 0_{[1]}, 1_{[1]})$
$l_{[1]} = a'_{[1]}$ and $b'_{[1]}$ and $c'_{[1]}$

Without changing satisfiability.

A satisfying solution for the original system can be obtained from a solution of (5) by a sign extension of the values of the reduced variables, e.gof the reduced variables, e.g., $\mathbf{x'}_{[2]} = 00$, $\mathbf{y'}_{[2]} = 01$, $\mathbf{z'}_{[2]} = 10$, yields $\mathbf{x}_{[8]} = 00000000$, $\mathbf{y}_{[8]} = 00000001$ and $\mathbf{z}_{[4]} = 11111110$.

The process of scaling down signal widths is separated into two sequential phases.

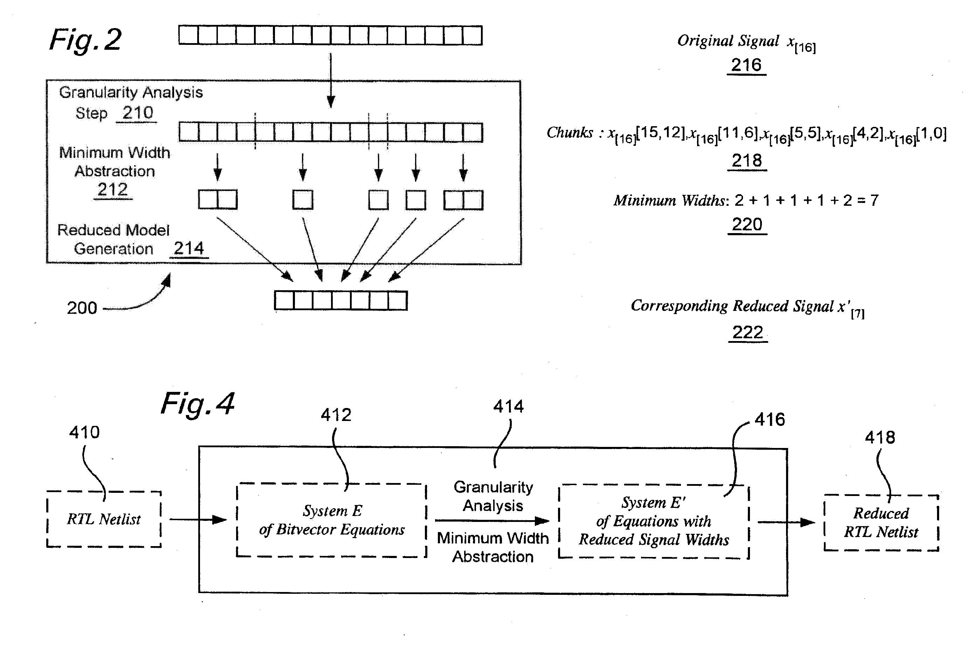

The basic idea of this abstraction technique is shown in the flow chart, 200, of Figure 2, as will be described below. First, the coarsest granularity of each word-level signal $x_{[16]}$ is computed, as determined by the structural data dependencies in a granularity analysis step, 210. A granularity is a separation of a signal into several contiguous chunks, 218, which indicate the coarsest possible subsumptions of individual bits of the signal, which are treated in the exact same manner with respect to structural data dependencies. Then, for each chunk, the necessary minimum width, 220, is computed, as required by dynamical data dependencies in a minimum width abstraction step, 212. According to these computed minimum chunk widths, the reduced width for the corresponding variable is reassembled, in a reduced model generation step, 214, to be provide a reduced signal, 222.

The present invention provides an equational theory $BV_{\text{ext}}$ of fixed-size bitvectors, derived from the core theory of bitvectors. Let B = {0, 1} denote the set of bit values 0 and 1. A bitvector of width $n \in \mathbb{N}_+$ is a vector element of $B^n$, consisting of $n$ individual bits which are indexed from right to left, starting with index 0. Bitvectors are written as binary bitstrings, and, accordingly, the set $B^n$ of bitvectors of length $n$ is denoted by $B_{[n]}$. The invention provides a bitvector variable definition wherein, for $n \in \mathbb{N}_+$, a bitvector variable $x_{[n]}$ of width n is a typed variable, representing fixed-size bitvectors $v \in B_{[n]}$ of width n.

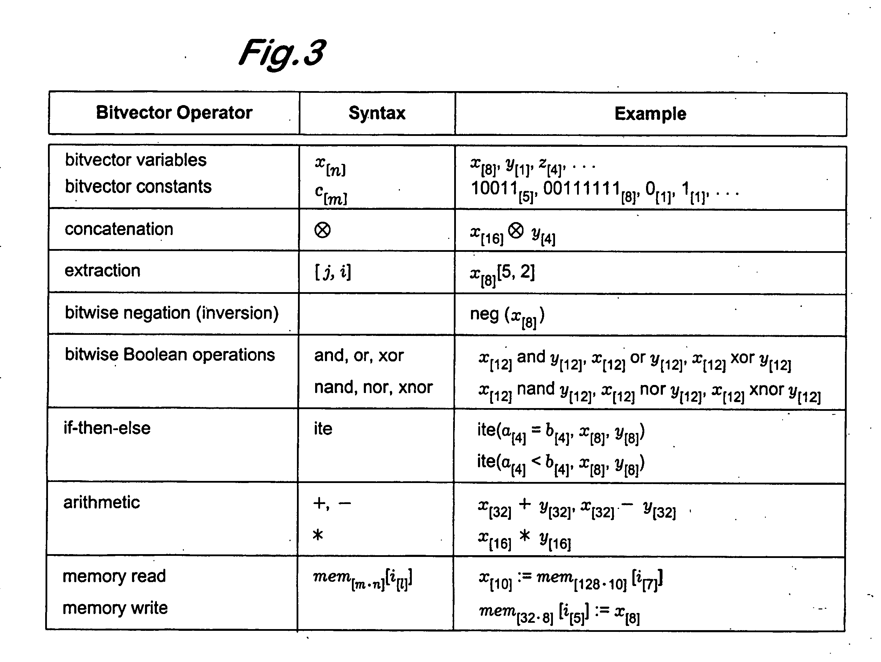

Fixed-size in this context means that for each bitvector variable the width $_n$ is a fixed (but arbitrary) positive natural number. We write $x_{[n]}[i]$ to refer to the $i^{\text{th}}$ bit of $x_{[n]}$. $BV_{\text{ext}}$ includes bitvector variables and bitvector constants $c_{[n]}$, $n \in \mathbb{N}_+$ and $c \in B_{[n]}$. The present invention, compared to the core theory of bitvectors, provides additional high-level operators as tabulated in Figure 3. Further operators, like shifts, rotations or further comparisons, are conveniently expressed within this theory. The Boolean predicates = and < occurring in the guards of **ite** (if-then-else) expressions, are defined on two bitvector arguments of equal width. Equality is defined bitwise, whereas < is defined according to the lexicographical order of bitstrings.

The set of terms is defined over a set of free bitvector variables and the operators shown in Figure 3. If the terms are "well-formed" then the terms require variable widths to comply with operator demands, and index expressions must not exceed the widths of argument terms. A valuation is an assignment of values to the bitvector variables occurring in the terms. A system $E$ of equations over such terms is satisfiable if there exists a valuation of the variables such that all equations of $E$ hold simultaneously. Correspondingly, we define the term "valid" such that $E$ is universally valid if all possible valuations satisfy $E$.

In a fourth example, $x_{[16]}$ $y_{[4]}$ and $z_{[4]}$ are bitvector variables. Consider:

1. $x[16][15,8] \otimes x_{[16]}[7,0] = x_{[16]}$
2. $x_{[16]} = \text{neg}(x_{16})$
3. $y_{[4]}$ and $1100_{[4]} = z_{[4]}$

Equation 1 is universally valid and Equation 2 is unsatisfiable. Equation 3 is satisfiable, e.g. by $y_{[4]} := 0111_{[4]}$ and $z_{[4]} := 0100_{[4]}$, but not universally valid.

In a fifth example $x_{[8]}$ and $y_{[4]}$ are bitvector variables.

$$\mathbf{x_{[8]}} \quad = \quad \mathbf{y_{[4]}} \otimes \mathbf{y_{[4]}}$$

$$x_{[8]}[4,4] = \quad neg\ (x_{[8]}\ [0,0])$$

Consider the system of equations given above. Taken separately, the first and second equations are satisfiable. However, the system of equations, as a whole, is unsatisfiable.

Referring now to Figure 4, there is illustrated the steps of the proposed abstraction technique in accordance with the present invention. As a first step, the RTL representation of design, 410, and property is translated into a system $E$, 412, of equations of bitvector terms over $BV_{ext}$, such that:

$$E\ is\ satisfiable \Leftrightarrow \quad Property\ does\ not\ hold\ for\ the\ Design \qquad (5)$$

A possible solution of $E$, if existent, would be a counterexample which would give value assignments to all circuit signals, such that the property does not hold for these assignments.

The data dependencies within the bitvector equations of $E$ are analysed, 414, and a second system $E'$, 416, of bitvector equations is computed, in which the type (i.e. the width) of each bitvector variable is reduced to a smallest number of bits that is possible with respect to the abstraction technique, such that:

$$E'\ is\ satisfiable \Leftrightarrow E\ is\ satisfiable \qquad (6)$$

From (5) and (6) it follows that:

$$E'\ is\ satisfiable \Leftrightarrow Property\ does\ not\ hold\ for\ the\ Design \qquad (7)$$

$E'$ is translated back to an RTL netlist, 418, representing a scaled down version of the original design. According to (7), the property checking task can be completely carried out on the reduced model.

Given a system $E$ of bitvector equations over $BV_{ext}$, structural and functional dependencies are imposed on the bitvector variables by the high-level operators occurring in the equations. Dependencies may be found between complete variables or only between certain parts. For each variable, the present invention analyses such dependencies and determines the contiguous parts in which all bits are treated uniformly with respect to data dependencies.

Further definitions are now provided for 'Chunk' and 'Granularity': A chunk $x_{[n]}{<}j,i{>}$, $o \le i \le j < n$, of a bitvector variable $x_{[n]}$ is a syntactical representation for a contiguous part of $x_{[n]}$, i.e. $x_{[n]}\ {<}j,i{>} := x_{[n]}\ [j,i]$.

Chunks are used to describe the above-mentioned contiguous parts of bitvector variables.

A granularity of a bitvector variable $x_{[n]}$ is any ordered decomposition of $x_{[n]}$ into chunks $\{x_{[n]}{<}j_2,i_1{>},\ x_{[n]}\ {<}j_q,i_q{>}\}$ $0 = i_1{<}j_1 = 1 = i_2 < j_2 +1 = ... = i_q < j_q + 1 = n$, such that

$$x_{[n]}\ [j_q,i_q] \otimes ... \otimes\ x_{[n]}[j_2,i_2]\ \otimes x_{[n]}[j_1,i_1] = x_{[n]}.$$

is a tautology

In a sixth example, $x_{[16]}$ is a bitvector variable. $\{x_{[16]}{<}15,18{>},\ x_{[16]}{<}7,4{>},\ x_{[16]}{<}3,0{>}\}$ is a granularity of $x_{[16]}$, whereas $\{x_{[16]}{<}15, 10{>},\ x_{[16]}{<}5,0{>}\}$ and $\{ x_{[16]}{<}15,5{>},\ x_{[16]}{<}10,0{>}\}$ is not.

Granularities are used to describe how different data dependencies exist for different chunks of a bitvector variable. Non-uniform structural dependencies occur whenever a variable (or a term) is not treated as a whole, but separated into parts upon which different operations are performed, e.g. by extractions or concatenations.

The relation between granularities and structural dependencies is shown in a further example: consider the following bitvector equation:

$$x_{[8]} = y_{[4]} \otimes z_{[4]}$$

The concatenation on the right hand side of the equation imposes different dependencies on the upper and lower part of $x_{[8]}$, the first depending on $y_{[4]}$, the latter on $z_{[4]}$. This is described by the granularity $\{x_{[8]}(7,4), x_{[8]}(3,0)\}$.

For each bitvector variable $x_{[n]}$, the method in accordance with one aspect of the invention computes the coarsest possible granularity which describes the splitting of data dependencies for $x_{[n]}$, as imposed by the equations of $E$. Slicing is performed only if necessary. For example, the equation $x_{[16]} = y_{[16]}[15,12] \otimes y_{[16]}[11,0]$ is equivalent to $x_{[16]} = y_{[16]}$ and does not require slicing of $x_{[16]}$. Hence, initially a normalization of all bitvector terms is performed. The computation of the coarsest granularities is carried out using an equivalence class structure which groups chunks between which functional dependencies are detected.

Granularity analysis and functional dependencies are shown in another example. The equation given in the fourth example imposes functional dependencies between $x_{[8]}[7,4]$ and $y_{[4]}[3,0]$ and between $x_{[8]}[3,0]$ and $z_{[4]}[3,0]$. The resulting equivalence classes are $\{x_{[8]}<7,4>, y_{[4]}<3,0>\}$ and $\{x_{[8]}<3,0>, z_{[4]}<3,0>\}$. As a second example consider $x_{[16]} = y_{[16]}$ or $z_{[16]}$. Here, $x_{[16]}$, $y_{[16]}$ and $z_{[16]}$ are related to each other by a bitwise Boolean operator, requiring that all three go into the same equivalence class $\{x_{[16]}<15,0>, y_{[16]}<15,0>, z[16]<15,0>\}$.

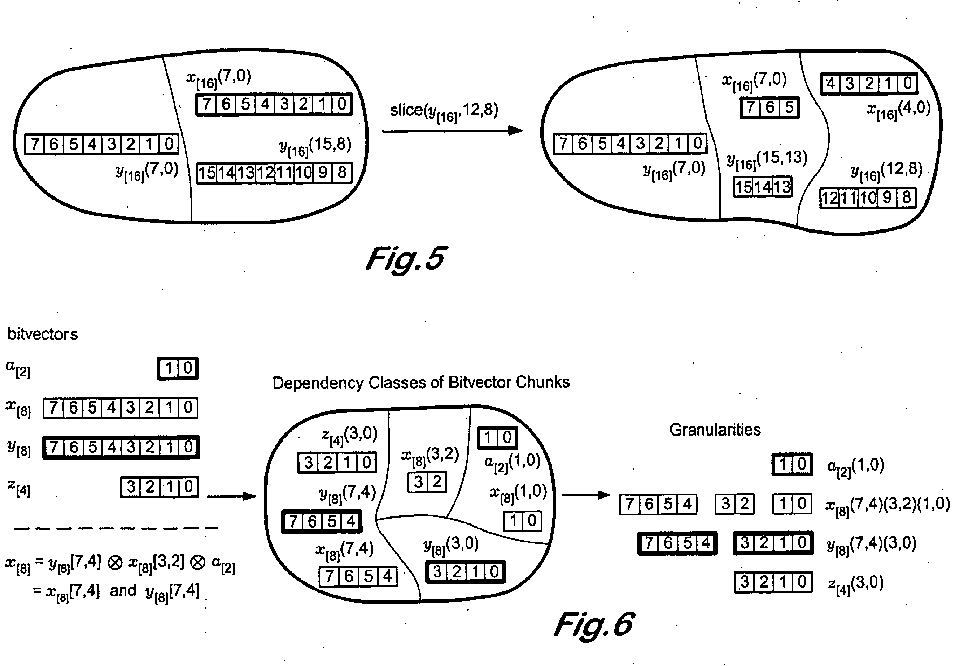

The equivalence class computation works incrementally and can efficiently be performed by employing a union-find algorithm, which, besides the known **union** () and **find**() operations, defines a new procedure **slice**(). Initially, in each bitvector group of classes, 510, variable $x_{[n]}$ resides in its own singleton equivalence class: $\{x_{[n]}<n - 1,0>\}$. Find $(x_{[n]},i)$ yields the (non ambiguous) equivalence class, which includes a chunk of $x_{[n]}$ which contains bit position $i$, union () performs the usual set union of two classes, and **slice**$(x[n],j,i)$ calls **find**$(x_{[n]},i)$ and **find**$(x_{[n]},j)$ and splits all chunks of the respective classes at the bit positions corresponding to $i$ and $j$ and groups the originating parts in two new equivalence classes, as illustrated in Figure 5, with a second group of classes, 512.

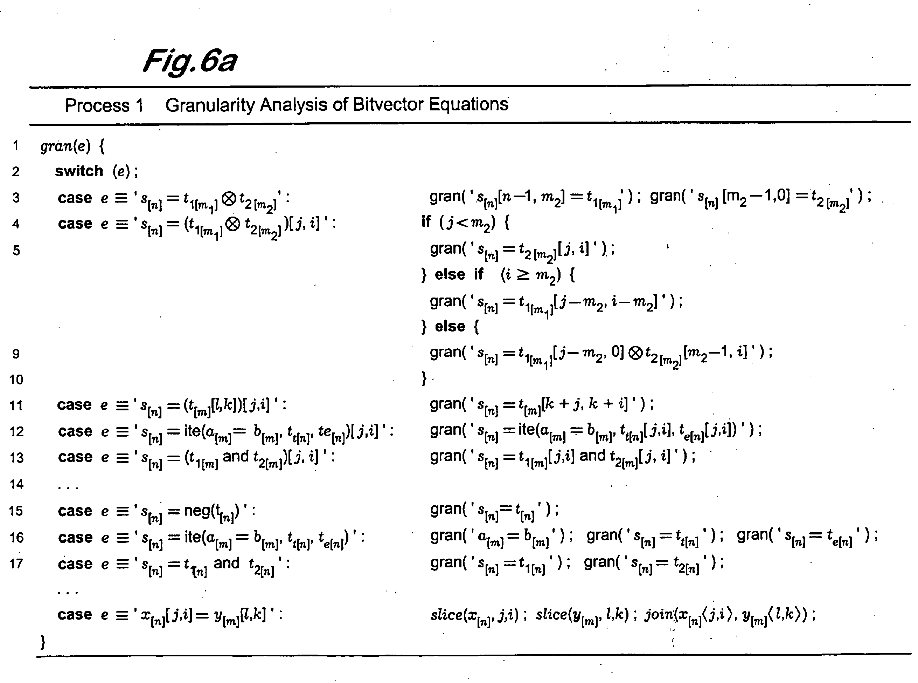

Figure 6 exemplifies a granularity analysis in terms of bitvectors, dependency classes of bitvectors chunks and granularities. Each bitvector equation $e$ is processed sequentially by the analyser and the next state of the equivalence class structure is computed by means of the procedure gran(e), which is outlined in process 1 as shown in Figure 6a. Once all bitvector equations have been processed, for each bitvector variable the coarsest possible granularity is given by the state of the equivalence classes.

The granularity analysis decomposes the initial satisfiability problem for $E$ into a number of independent satisfiability problems, characterized by the computed equivalence classes. The solutions of these problems can be characterized by bitwise bitvector functions, as will be defined as follows:

Let $n \in \mathbb{N}_+$: and $k \in \mathbb{N}_+$, a k-ary bitvector function on bitvectors of width n is a function.

$$F_{[n]} : \underbrace{B_{[n]} \times .... \times B_{[n]}}_{k} \to B_{[n]}$$

Bitvector functions $G_{[1]} : B \times ... \times B \to B$ on bitvectors of width 1 are called Boolean functions.

Let $n \in \mathbb{N}_+$, $k \in \mathbb{N}_+$, and $F_{[n]}$ be a k-ary bitvector function on bitvectors of width n. $F_{[n]}$ is a bitwise bitvector function if there exists a k-ary Boolean function $G_{[1]}$ such that:

$$F_{[n]} \equiv (G_{[1]}, G_{[1]}, ... G_{[1]}) \text{ i.e. } \forall i \in \{0,...,n-1\} : F_{[n]}(x^1_{[n]},...,x^k_{[n]})[i] = G_{[1]}(x^1_{[n]}[i],...,x^k_{[n]}[i])$$

$F_{[n]}$ operates uniformly on all bit positions of its arguments according to $G_{[1]}$. If two k-ary bitwise Boolean functions $F^1_{[n]}$ and $F^2_{[m]}$, one taking bitvectors of width $n$ as arguments and the other bitvectors of width $m$, operate according to the same Boolean function $G_{[1]}$, then this correspondence is denoted by $F^1_{[n]} \simeq F^2_{[m]}$. in a ninth example

$x_{[8]}$ , $y_{[8]}$, $z_{[8]}$ are bit-vector variables of width 8 and let $x'_{[4]}$ $y'_{[4]}$ , $z'_{[4]}$ , be bit-vector variables of width 4. Let

$F^1_{[8]}(x_{[8]} , y_{[8]}, z_{[8]}) := x[8]$ and (neg ($y_{[8]}$) *or* $z_{[8]}$); and

$F^2_{[4]}(x'_{[4]}, , y'_{[4]}, z'_{[4]}): = x'_{[4]}$ and (neg ($y'[4]$)) *or* $z'_{[4]}$); and

$F^1_{[8]}$ and $F^2_{[4]}$ are bit-wise bit-vector functions with $F^1_{[8]} \simeq F^2_{[4]}$. Furthermore, consider:

$G F^3_{[8]}(x_{[8]} , y_{[8]} , z_{[8]} ):= (x_{[8]}[7,4]$ and $y_{[8]}[7,4]) \otimes z_{[8]}[3,0];$

$F^3_{[8]}$ is a bitvector function, but not bit-wise.

Let $C$ be one of the equivalence classes computed by the granularity analysis. The set of all satisfying solutions of $E$, projected to the chunks contained in $C$, can be characterized by a first theorem with respect to satisfiability:

$$\text{If } C = \{ x^l_{[n1]} <j_1, i_1 >,\dots, x^k_{[n]} <j_k, i_k > \},$$

with $j_1 - i_1 = \dots = j_k - i_k = n$, then there exists a k-ary bit-wise bit-vector function: $F_{[n]}(x^1_{[n]} <j_1, i_1 >,\dots,x^k_{[n]} <j_k, i_k>)$ such that the set of satisfying solutions of the equation

$$F_{[n]}(x^1_{[n]} <j_1, i_1 >, x^2_{[n]} < j_2, i_2 >,\dots,x^k_{[n]} < j_k, i_k >) = \underbrace{000\dots0,}_{n}$$

describes the set of solutions of **E**, projected to $x^1_{[n]} <j_1, i_1 >,\dots,x^k_{[n]} <j_k, i_k>$.

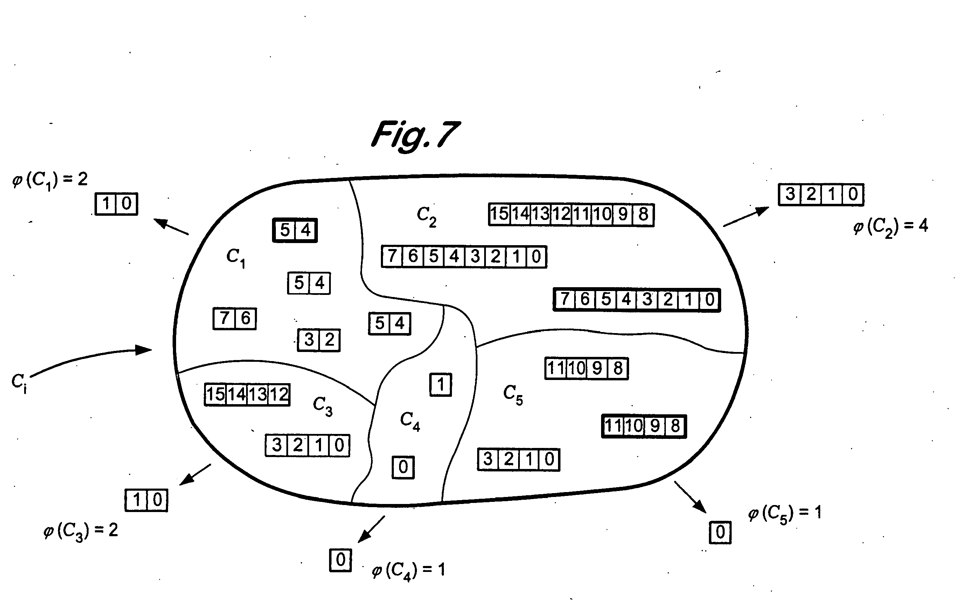

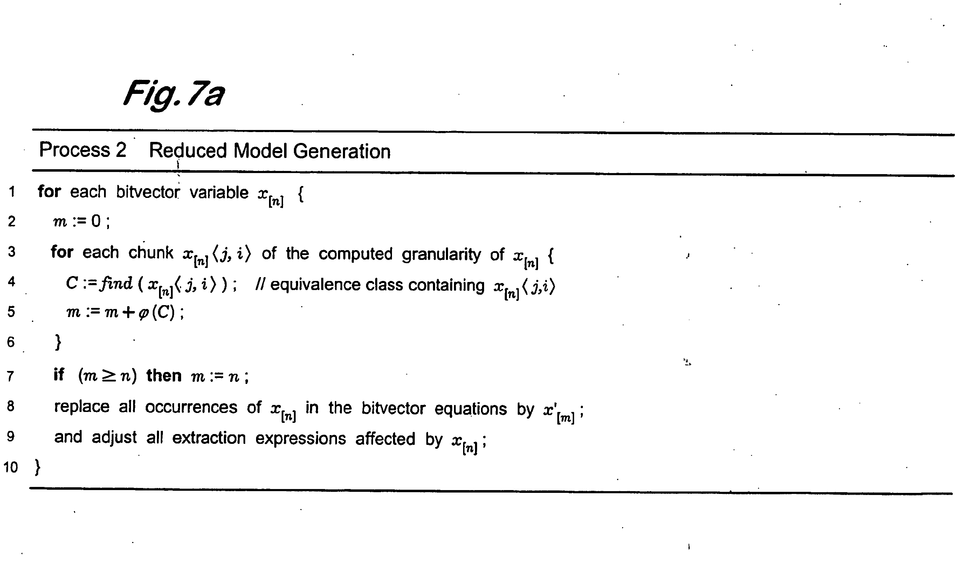

Referring now to Figure 7, there is shown an equivalence class $C_i$ containing chunks of width $n_i$. For each such class $C_i$, a $\varphi(C_i) \le n_i$ is computed, $\varphi(C_i)$ depending on the number of chunks residing in $C_i$ and on the number of possible inequalities between these chunks, as determined by the guards of if-then-else expressions in the bitvector equations.

The satisfiability problem $B_{[ni]}$, which is related to $C_i$ according to method 1, is satisfiable if and only if the modified satisfiability problem $B_{[\varphi(Ci)]}$, in which each chunk of $C_i$ is replaced by a corresponding chunk of width $\varphi(C_i)$, i.e. we have $B_{[ni]} \simeq B_{[\varphi(Ci)]}$, is satisfiable.

We will now consider the reduction of bitvector widths with a second method: Let $V_{[n]} = \{x^1_{[n]}, x^2_{[n]}, x^k_{[n]}\}$ be a finite set of $k$ bitvector variables of width $n \in \mathbb{N}_+$. Let $F_{[n]}(x^1_{[n]}, x^2_{[n]},\dots,x^k[n])$ be a k-ary bitwise bitvector function on $V_{[n]}$, and

let $I \subseteq V_{[n]} \times V_{[n]}$ be a set of pairs of elements of $V_{[n]}$, such that $P_1,\dots, P_q$ are the connected components of the corresponding undirected graph $(V_{[n]}, I)$. Let

$$\varphi(V_{[n]}, E) := |V_{[n]}| - |\{P_1,\dots,P_q\}| = k-q$$

and let m := max $\{\varphi(V_{[n]}, E), 1\}$. Then the following equivalence holds:

There exists a valuation $v$ of $x^1_{[n]},\dots, x^k_{[n]}$ There exists a valuation $v$ of $x'^1_{[m]},\dots, x^k_{[m]}$ such that $F_{[n]}(v(x^1_{[n]}), \dots, v(x^k_{[n]})) = 0_{[n]} \Leftrightarrow$ of such that $F_{[m]}(v(x'^1_{[m]}),\dots,v(x^k_{[m]})) = 0_{[m]}$ EINBETTEN *and for all* $(x^i_{[n]}, x^j_{[n]}) \in I$: $v(x^i_{[n]}) \ne v(x^j_{[n]})$ *and for all* $(x^i_{[m]}, x^j_{[m]}) \in I$: $v(x^i_{[m]}) \ne v(x^j_{[m]})$

where $F_{[m]}(x'^1_{[m]}, x^2_{[m]},\dots,x^k_{[m]})$ is the corresponding bitwise bitvector function with $F_{[m]} \simeq F_{[n]}$ on bitvectors $x^1_{[m]}, x^2_{[m]},\dots,x^k_{[m]}$ of width m.

The information about possible inequalities is obtained during the Granularity Analysis and annotated within the equivalence classes. For each equivalence class $C$ we define $\varphi(C) := \max\{\varphi(V_{[n]}, I), 1\}$, where $V_{[n]}$ is the set of chunks in $C$, and $I$ is the set of possible inequalities annotated to $C$. The reduced system $E'$ of bitvectors equations is constructed according to process 2.

**Example 10.** Let $x_{[8]}, y_{[16]}, z_{[16]}$ be bitvector variables and assume that $E$ contains the following equation:

$$x_{[8]} = (y_{[16]} \text{ and } z_{[16]})[15,8] \qquad (8)$$

Assume that granularity analysis and minimum width abstraction yield the following results:

$$C_i \quad = \quad \{\ldots, x_{[8]}{<}7,0{>}, y_{[16]}{<}15,8{>}, z_{[16]}{<}15,8{>}, \ldots\}; \quad \varphi(C_i) \quad = \quad 2$$

$$C_{i+1} \quad = \quad \{\ldots, y_{[16]}{<}7,0{>}, z_{[16]}{<}7,0{>}, \ldots\}; \qquad \varphi(C_{i+1}) = \quad 3$$

*The granularity of $y_{[16]}$ for example, is given by:*

$$\{ y_{[16]}{<}15,8{>}, y_{[16]}{<}7,0{>}\}, \quad i.e. \quad y_{[16]}[15,8] \otimes y_{[16]}[7,0]$$

According to the minimum chunk widths, the corresponding reduced variable is assembled as follows:

$$\{y'_{[5]}(4,3), \; y'_{[5]}{<}2,0{>}\}, \qquad i.e. \quad y'_{[5]} = y'_{[5]}[4,3] \otimes y'_{[5]}[2,0]$$

Hence, the reduced equation of E', which corresponds to (8) of E is:

$$\ldots$$

$$x'_{[2]} \quad = \quad (y'_{[5]} \text{ and } z'_{[5]})[4,3] \qquad (9)$$

Indices of extraction expressions are modified according to the new chunk widths.

Method 1 and method 2 yield that the original system $E$ of bitvector equations is satisfiable if and only if the reduced system $E'$, where all chunks of each class $C_i$ are reduced to a width, $\varphi(C_i)$, is satisfiable.

Accordingly a third method is applied: The reduced system E' of bitvector equations which results from the proposed abstraction technique is satisfiable if and only if the original equational system E is satisfiable. For each solution of the reduced system a solution of the original system can be computed.

It is to be understood that $\varphi(C)$ depends only on the sizes and number of the connected components of the corresponding undirected graph of $C$ and $I$. The computation of the number of connected graph components for each class can efficiently be done by using a union-find algorithm, and, moreover, can be embedded within the computation of the equivalence classes during the granularity analysis.

Let $V_{[n]} = \{x^1_{[n]}, \ldots, x^k_{[n]}\}$ be a set of bitvector variables, $B[n](x^1_{[n]}, \ldots, x^k_{[n]})$ be a bitwise bitvector function and $I \subseteq V_{[n]} \times V_{[n]}$. For $m \in \mathbb{N}_+$, let $B_{[m]}$ denote the corresponding bitwise bitvector function with $B_{[m]} \simeq B_{[n]}$ on bitvector variables $x^1_{[m]}, \ldots, x^k_{[m]}$ of width $m$, and let $P(B_{[m]}, I)$ denote the following satisfiability problem:

There exists a valuation $v$ of $x^1_{[m]}, \ldots, x^k_{[m]}$ such that:

$$P(B_{[m]}, I) \Leftrightarrow B_{[m]}(v(x^1_{[m]}), \ldots, v(x^k_{[m]})) = 0_{[m]} \text{ and for all } (x^i_{[n]}, x^j_{[n]}) \in I : v(x^i_{[m]}) \neq v(x^j_{[m]})$$

According to Theorem 1, each satisfiability problem belonging to an equivalence class C can be described by a bitwise bitvector function $\boldsymbol{B}_{[n]}$ and a set of inequalities $\boldsymbol{I}$. The reduced chunk width $m := \varphi(C)$ computed in Theorem 2 is independent of any further mathematical property of $\boldsymbol{B}_{[n]}$, i.e. we purposely abstract from the concrete aspects of $\boldsymbol{B}_{[n]}$ except for bitwise operation. $m$ is minimal with respect to this abstraction, which leads to a fourth theorem, relating to minimality:.

Let $V_{[n]} = \{x^1_{[n]},\dots ,x^k_{[n]}\}$ be a finite set of k bitvector variables of width $n \in \mathbb{N}_+$. Let $I \subseteq V_{[n]}$, and let m := max $\{ \varphi(V_{[n]}, I), 1\}$. Then there exists a k-ary bitwise bitvector function $\boldsymbol{B}_{[n]}(x^1_{[n]},\dots ,x^k_{[n]})$ such that

$$P(\boldsymbol{B}_{[m]},\boldsymbol{I}) \quad \Leftrightarrow \quad P(\boldsymbol{B}_{[n]},\boldsymbol{I}) \qquad and\ not \qquad (P(\boldsymbol{B}_{[m-1]},\boldsymbol{I}) \quad \Leftrightarrow \quad P(\boldsymbol{B}_{[n]},\boldsymbol{I}))$$

i.e. m is the minimum width for which $P(\boldsymbol{B}_{[m]},\boldsymbol{I})$ is satisfiable if and only if $P(\boldsymbol{B}_{[n]},\boldsymbol{I})$ is satisfiable.

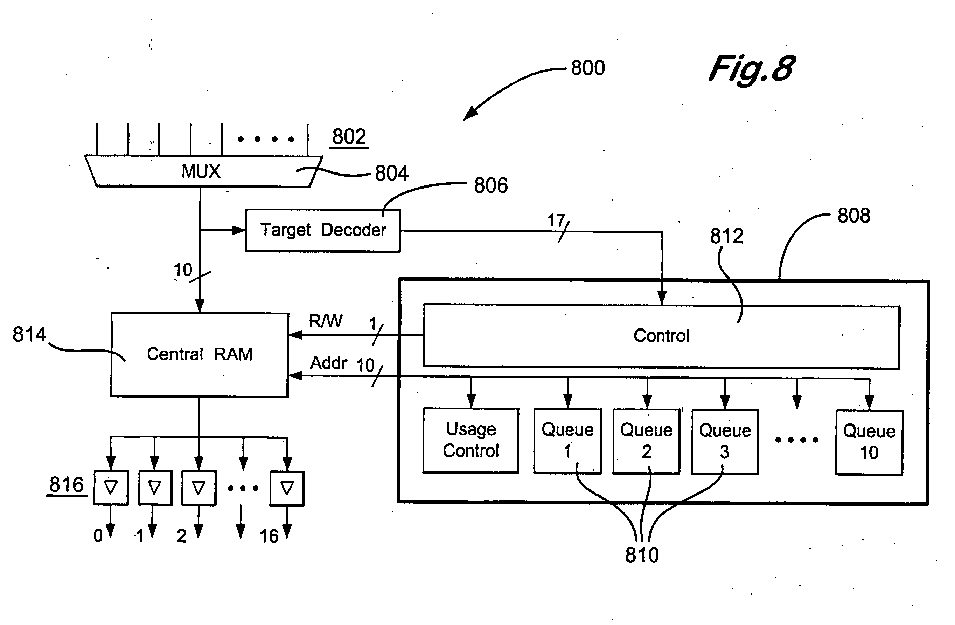

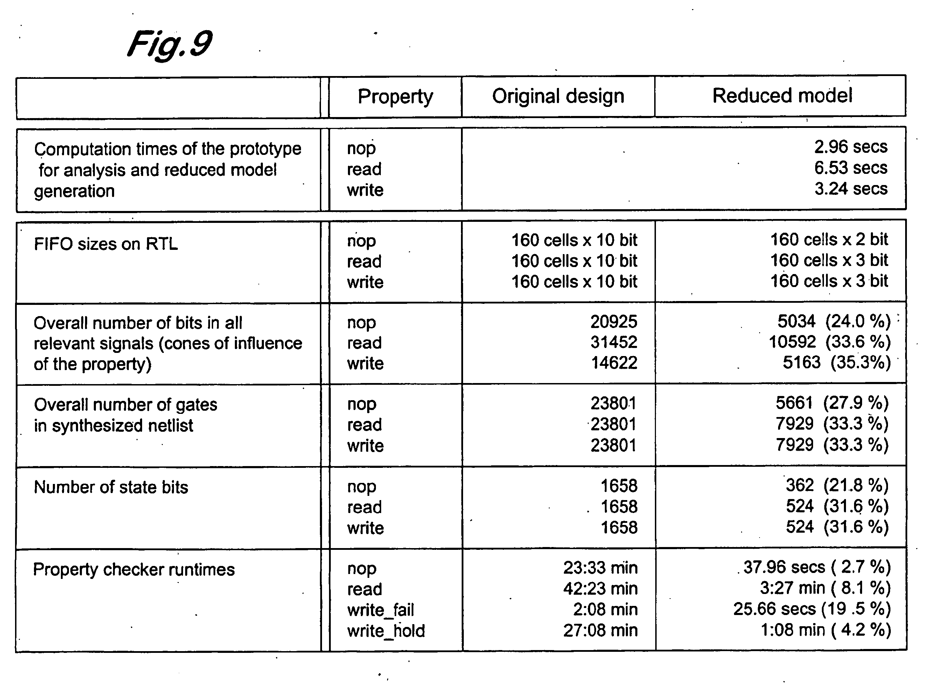

A prototype system was implemented in C++ and tested in several case studies at the Design Automation department of Siemens Corporation in Munich and at the Computer Network Peripherals department of Infineon Technologies in San Jose, CA. All test cases were run on an Intel Pentium II PC with a 450 MHz CPU, 128 MB main memory and a Linux operating system. Referring to Figure 8, which shows a block diagram of an ATM switching element 800, a case study of an address management unit of an ATM switching element will now be discussed. Results are tabulated in Figure 9. The design comprised of approximately 3000 lines of Verilog code, the netlist synthesis comprised of approximately 24.000 gates and 35.000 RAM cells. Signals input to cell inputs 802, which are multiplexed by multiplexer, 804, to a central RAM, 814, or via a target decoder 806 to an RTL unit 808, which provides signals to the central RAM. The RTL unit incorporates 16 FIFO queue buffers, 810, and complex control logic, 812. Memory addresses are fed to 33 input channels to the multiplexer unit, 804, stored in FIFO's and, upon request, output from one of 17 output channels, 816, while the cell sequence is preserved and no addresses are allowed to be dropped from the management unit.

The prototype was used as preprocessor to a collection of known property checking tools. Three different properties, nop, read and write were required to be verified, which specified the intended behaviour within a range of 4 timesteps (nop, write), respectively 6 timesteps (read). It transpired that the write property did not hold due to a design bug in the Verilog code. A counterexample for the reduced model was found by the property checkers and recomputed by the prototype into a counterexample for the original design, whereupon the bug was fixed by the designers and the property was again checked on the corrected design (write fail, write hold). All runtimes on the reduced models were compared to those achieved on the original design without preprocessing. The results are given in CPU seconds (respectively minutes) and are shown in Figure 9.

The present invention provides a significant reduction in the different sizes of the design models and a tremendous drop in the runtimes of the property checkers. Design sizes could be reduced to approximately 30% of the original sizes, and runtimes dropped from between half and three quarters of an hour to minutes or even seconds. Note, in particular, that the computation times the prototype took to analyse the designs and generate the reduced models, ranging between 3 and 7 seconds, are negligible compared to the runtimes of the property checkers.

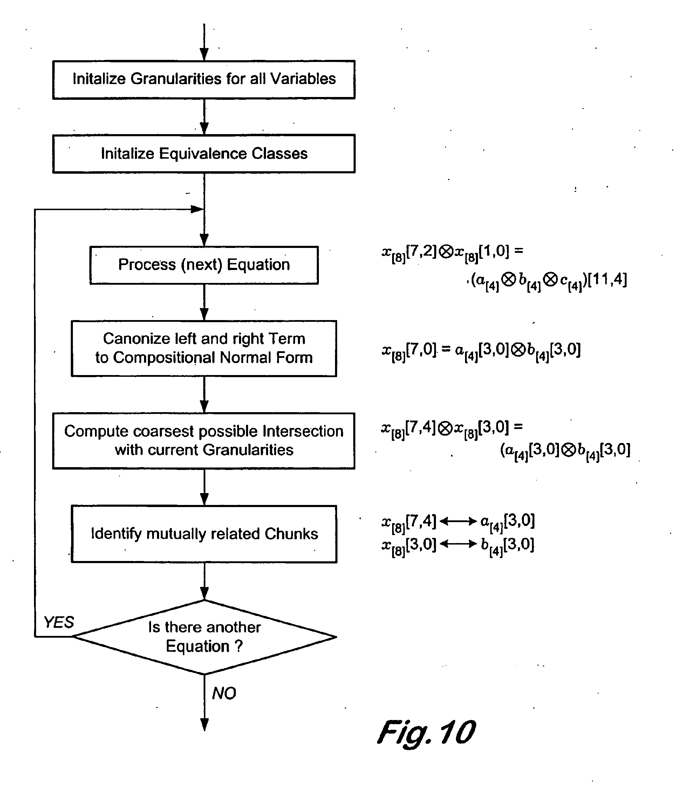

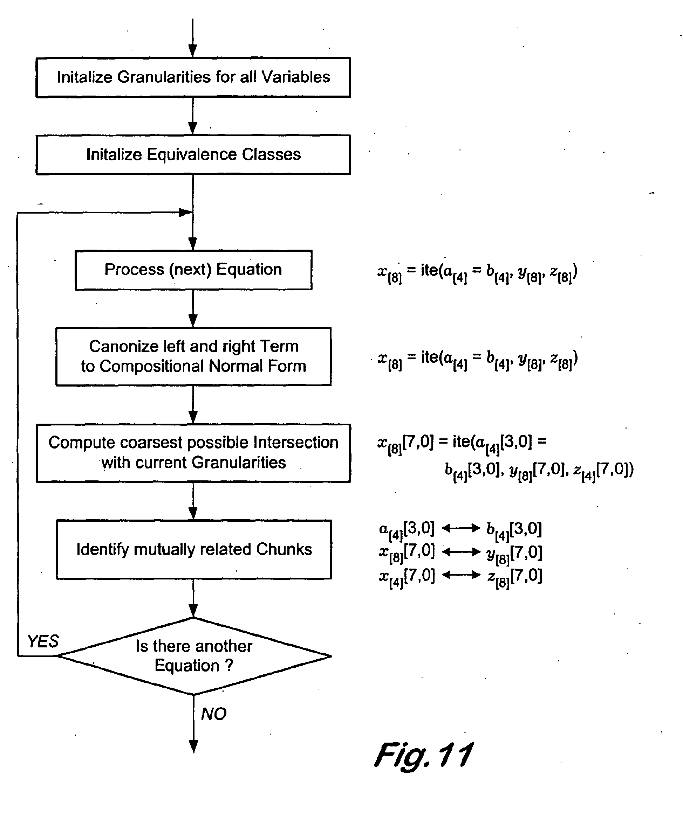

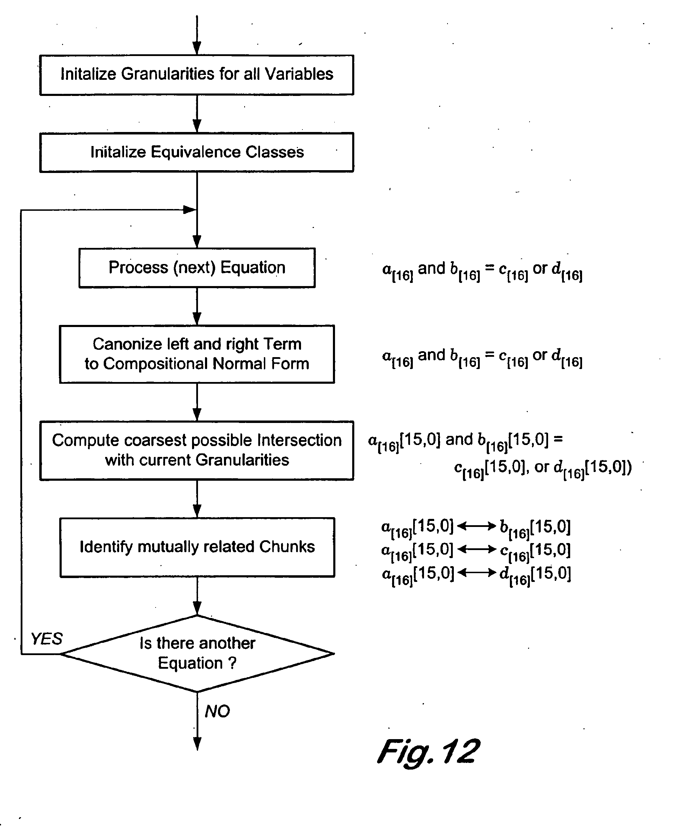

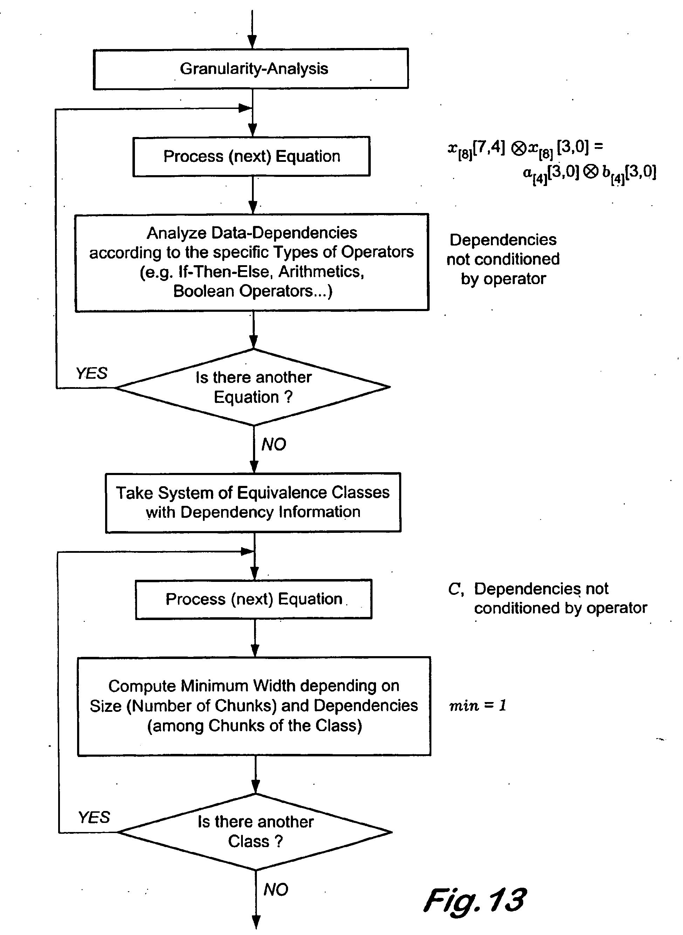

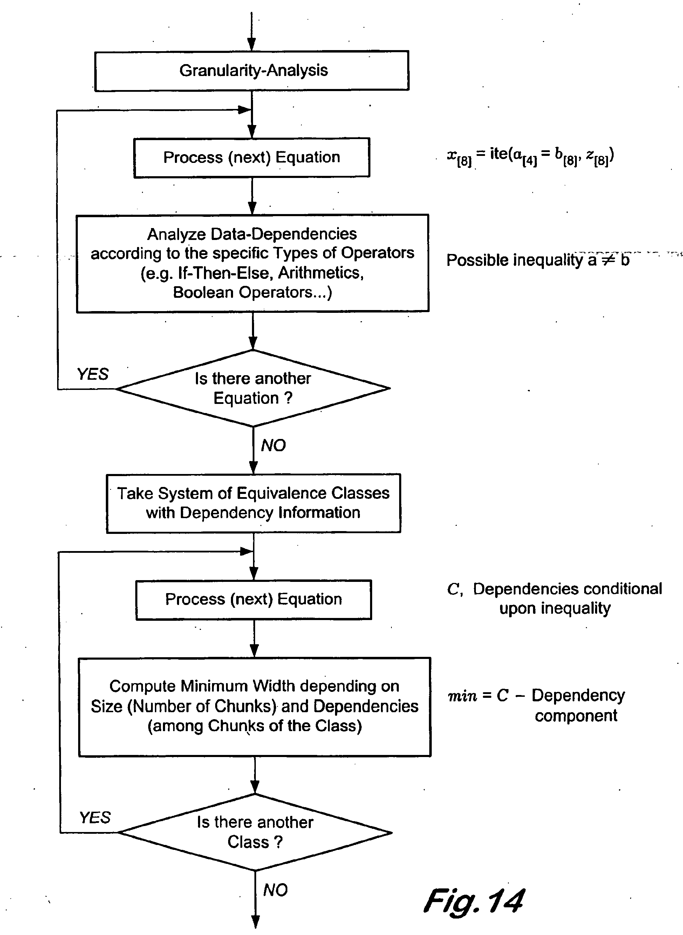

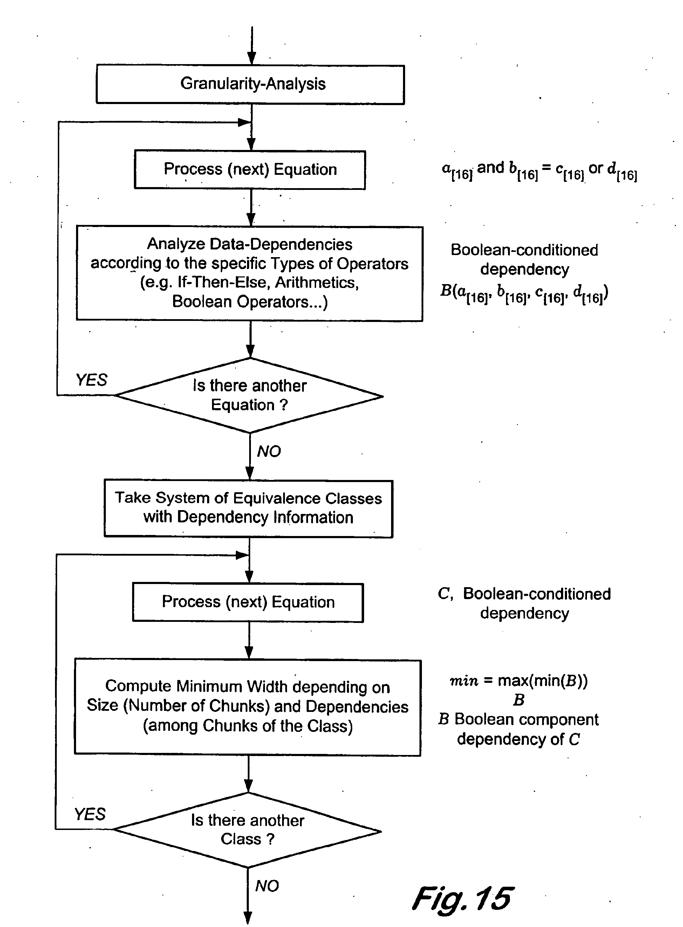

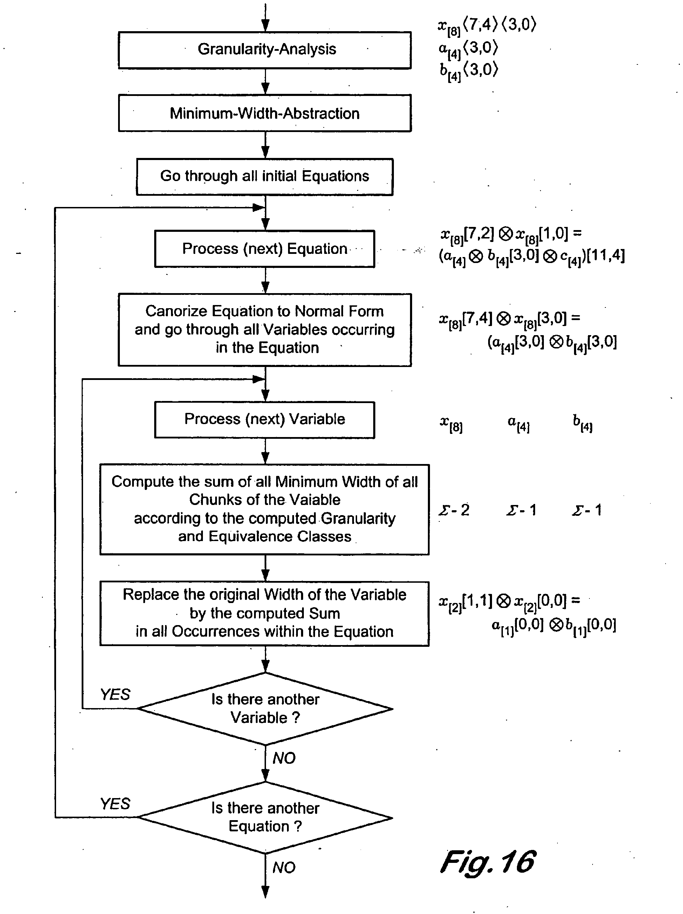

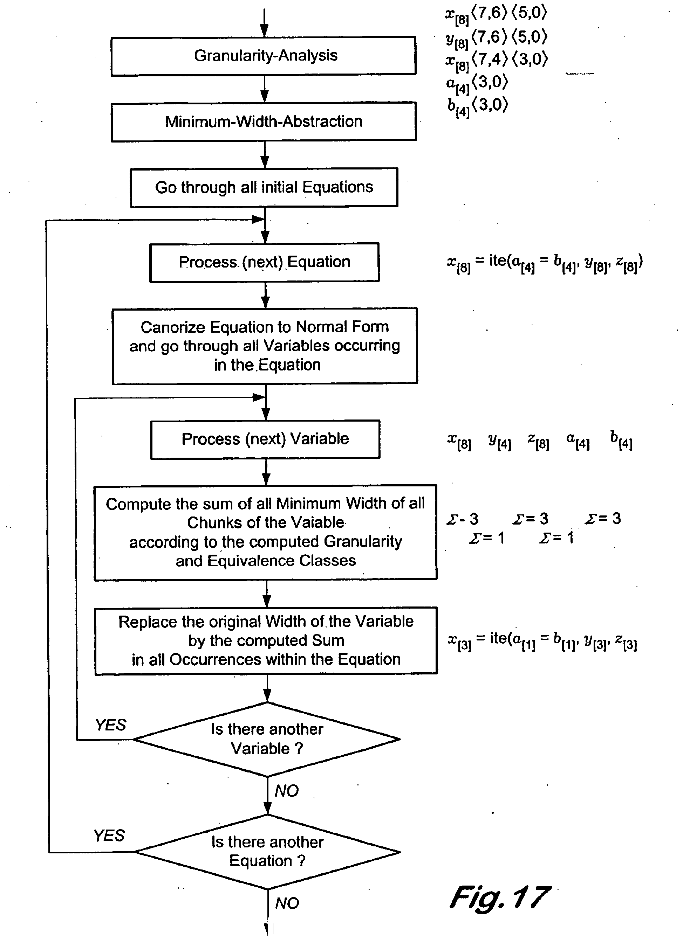

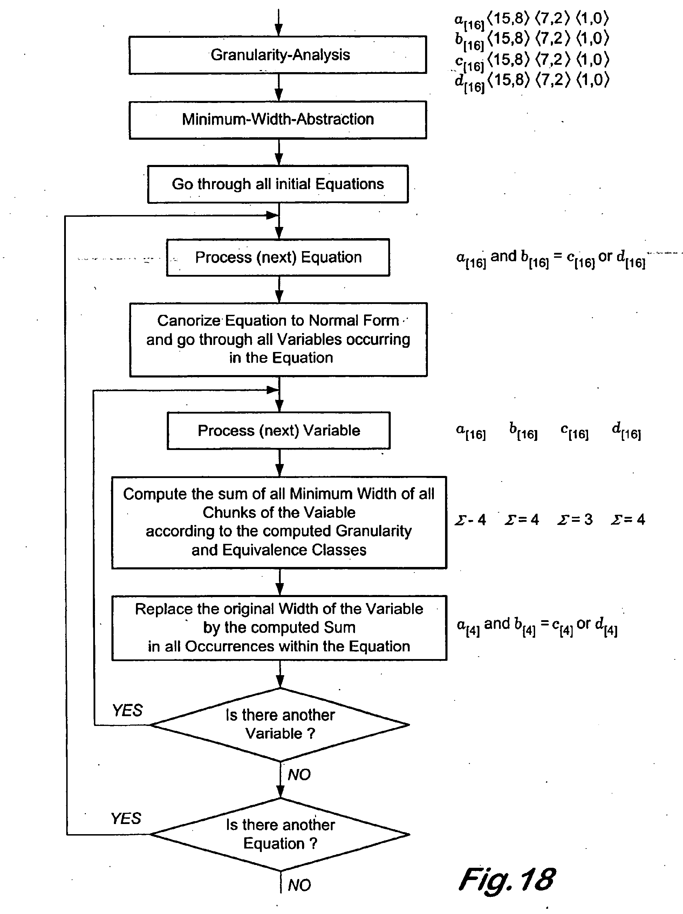

Figures 10-18 show flow charts for granularity analysis, minimal width abstraction, model generation, together with three corresponding examples.

Reduced runtimes and a reduced requirement for memory needed in computations is one requirement to match today's sizes of designs in hardware verification. The present invention provides an abstraction technique which, given a high-level circuit and a property specification, scales down the design by reducing the widths of input, output and internal signals. The method provides a one-to-one abstraction, which yields minimal models with respect to the minimality statement we have given. If a property fails, counterexamples for the original design can be computed from counterexamples for the reduced model. Pre- and post-processing of design and counterexample and the property checking process itself are strictly separated. The proposed method is independent of the system realization of the property checker and can be combined with a variety of existing verification techniques which take RTL netlists as input, no matter if the underlying prover engines operate on bit-level (like SAT or BDD-based approaches), or use high-level techniques (e.g. Integer Linear Programming, Arithmetic Constraint Solving). The approach is particularly well suited to SAT and BDD-based hardware verification, since the complexity of those techniques depends on the number of variables such provers have to deal with.

In known SAT and BDD-based circuit verification such variables are created (at least) for each single bit of each signal of the circuit. In Bounded Property Checking even multiple instances of each variable and each signal have to be created for each step of the considered interval of time. In practice, design sizes range from several thousands up to 2 - 5 million gates and typical bounded properties incorporate 2 - 30 timesteps depending on the field of application.

Appendix

Algorithm 2 **Reduced Model Generation**

```
1 for each bitvector variable x[n] {
2 m :=0;
3 for each chunk x[n](j,i) of the computed granulartiy of x[n] {
4 C := find (x[n](j,i)); // equivalence class containing x[n](j,l)
5 m := m + φ(C);
6 }
7 if (m≥n) then m := n;
8 replace all occurrences of x[n] of bitvector equations by x'[m]
9 and adjust all extraction expressions affected by x[n];
10}
```

**Claims**

**1.** A computer- implemented digital circuit design verification method comprising:

automatically determining for each property (112) of a non-reduced RTL model (118) a reduced RTL model (130) with reduced signal width for a design specification, which

reduced RTL model (130) retains the signal property of the non-reduced RTL model garanteering that the property holds for the original RTL ⇔ the property holds for the reduced RTL,

wherein the RTL model includes word-level signals comprising bit-vectors and, for each bit-vector variable, the method of reducing the RTL model is separated into two sequential steps;

the first step comprising the computation of the coarsest granularity of each word-level signal by means of an equivalence class structure whereby to separate each signal into several contiguous chunks which indicate the basic groups of bits with respect to structural data dependencies,

the second step comprising the computation of the minimum width with respect to dynamic data dependencies; and

subjecting the reduced RTL model (130) to a property checking process,

wherein prior to the determination of a reduced width RTL model, the design specification and properties of a digital circuit design are determined; and,

an RTL netlist of high level primitives is synthesised whereby the circuit is defined as an interconnection of control and data path portions, wherein signals of a width $n$ are determined such that $n \in \mathbb{N}_+$

and bitvectors of respective length determine the signal value.

**2.** A digital circuit design verification method in accordance with claim 1, wherein in the property checking process, an internal bit-level representation contains a bit-level variable for each bit of each word signal, which representation is sequentially passed to a verification engine and then to a property test unit which operates to provide a positive result if the circuit property holds true and which operates to provide a counterexample in the case that the property does not hold.

**3.** A digital circuit design verification method in accordance with claim 2, wherein, in the event that a counterexample is produced for the reduced RTL design, signal width enhancement is performed to create a counterexample for the original RTL.

**4.** A digital circuit design verification method in accordance with claim 1, wherein, for each bit-vector variable, the computation of coarse granularities is performed by means of an equivalence class structure, whereby an initial satisfiability problem can be considered as a number of independent satisfiability problems.

**5.** A digital circuit design verification method in accordance with claim 4, wherein the solution of the independent satisfiability problems can be determined by bit wise bit-vector functions.

6. A digital circuit design verification system **characterised in that** a pre-property checking unit is operable to reduce the widths of the signals occurring in an RTL model (118) of an input design specification to determine a reduced width RTL model (130) for each property of the non-reduced RTL model, which reduced RTL model (130) retains the signal property of the non-reduced RTL model, garanteering that the property holds for the original RTL ⇔ the property holds for the reduced RTL,
wherein the RTL model includes word-level signals comprising bit-vectors and, for each bit-vector variable, the system is operable to reduce the RTL model width of a signal in two sequential steps;
wherein, a first step, a coarse granularisation of each word-level signal is determined by means of an equivalence class structure whereby to separate each signal into several contiguous chunks which indicate the basic groups of bits with respect to structural data dependencies; and,
in a second step, a minimum width with respect to dynamic data dependencies is determined;
wherein the system further comprises a front end unit operable to receive input data relating to a design specification and property characteristics of a digital circuit design to be verified and is operable to provide an RTL netlist of the said design and property whereby the circuit can be defined as an interconnection of control and data path portions, wherein signals of a width $n$ are determined such that:

$$n \in \mathbb{N}_+ \quad \text{and}$$

bitvectors of respective length determine the signal value.

7. A digital circuit design verification system in accordance with claim 6, wherein the property checking unit is operable to receive a reduced RTL representation and to create an internal bit-level representation containing one bit for each bit of each word signal, which representation is sequentially passed to a verification engine and to a property test unit, the property test unit being operable to provide a positive result if the circuit property holds true and which operates to provide a counterexample in the case that the property does not hold.

8. A digital circuit design verification system in accordance with claim 7, wherein in a signal width enhancement unit is operable to receive a counterexample for reduced RTL data and to expand the signal width to provide a counterexample for the original RTL.

9. A digital circuit design verification system in accordance with claim 6, wherein the system is operable to arrange coarse granularities in terms of an equivalence class structure, whereby an initial satisfiability problem can be considered as a number of independent satisfiability problems.


**Patentansprüche**

1. Verfahren zur computerimplementierten Verifikation eines digitales Schaltungsdesigns, das Verfahren umfassend:

automatisches Bestimmen eines reduzierten RTL-Modells (130) mit reduzierte Signalbreite für jede Eigenschaft (112) eines nicht-reduzierten RTL-Modells (118) für eine Designspezifikation, wobei das reduzierte RTL-Modell (130) die Signaleigenschaft des nicht reduzierten RTL-Modells (118) behält, wobei sichergestellt wird, dass, die Eigenschaft für das originale RTL hält ⇔ die Eigenschaft für das reduzierte RTL hält,
wobei das RTL-Modell Word-level-Signale enthält, welche Bit-Vektoren umfassen, und wobei das Verfahren zum Reduzieren des RTL-Modells für jede Bit-Vektorenvariable in zwei sequentielle Schritte geteilt ist;
wobei der erste Schritt die Ermittlung der gröbsten Granularität jedes Word-level-Signals mittels einer Äquivalenzklassenstruktur umfasst, um jedes Signal in mehrere benachbarte Stücke aufzuteilen, welche die Bit-Basisgruppen bezüglich struktureller Datenabhängigkeiten angeben,
wobei der zweite Schritt die Ermittlung der minimal Weite bezüglich dynamischer Datenabhängigkeiten umfasst; und
das reduzierte RTL-Modell (130) einem Eigenschaftstest unterzogen wird,
wobei vor dem Bestimmen eines RTL-Modells mit reduzierter Breite, die Designspezifikationen und Eigenschaften eines digitalen Schaltungsdesigns bestimmt werden; und
eine RTL-Netzliste aus Highlevel-Elementen synthetisiert wird, wobei der Schaltkreis als eine Verbindung von Steuer- und Datenpfadabschnitten definiert ist, wobei Signale von einer Weite $n$ so bestimmt werden,

dass $n \in \mathbb{N}_+$

und Bit-Vektoren entsprechender Länge den Signalwert bestimmen.

2. Verfahren zur Verifikation eines digitalen Schaltungsdesigns gemäß Anspruch 1, wobei bei dem Eigenschaftstestvorgang eine interne bit-level Darstellung eine bit-level Variable für jedes Bit jedes Wort-Signals umfasst, wobei die Darstellung sequentiell zu einem Verifikationsmodul und dann zu einem Eigenschaftstest geleitet wird, welcher so arbeitet, dass ein positives Ergebnis bereitgestellt wird, wenn die Schaltkreiseigenschaft gültig bleibt, und welcher so arbeitet, dass ein Gegenbeispiel bereitgestellt wird, wenn die Eigenschaft nicht hält.

3. Verfahren zur Verifikation eines digitalen Schaltungsdesigns gemäß Anspruch 2, wobei in dem Fall, dass ein Gegenbeispiel für das reduzierte RTL-Design erzeugt wird, eine Signalweitenvergrößerung erfolgt, um ein Gegenbeispiel für die originale RTL zu erzeugen.

4. Verfahren zur Verifikation eines digitalen Schaltungsdesigns gemäß Anspruch 1, wobei für jeden Bit-Vektorenvariable die Ermittlung der gröbsten Granularität mittels einer Äquivalenzklassenstruktur erfolgt, wobei ein anfängliches Erfüllbarkeitsproblem als eine Anzahl von unabhängigen Erfüllbarkeitsproblemen betrachtet werden kann.

5. Verfahren zur Verifikation eines digitalen Schaltungsdesigns gemäß Anspruch 4, wobei die Lösung der unabhängigen Erfüllbarkeitsprobleme mittels bit-weiser Bit-Vektorenfunktionen bestimmt werden kann.

6. System zur Verifikation eines digitalen Schaltungsdesigns, **dadurch gekennzeichnet, dass** eine Voreigenschaftstesteinrichtung so arbeiten kann, dass die in einem RTL-Model (118) einer Eingangsdesignspezifikation auftretenden Signalweiten so reduziert werden können um ein RTL-Modell (130) mit reduzierter Weite für jede Eigenschaft des nicht reduzierten RTL-Modells zu bestimmen, wobei das reduzierte RTL-Modell (130) die Signaleigenschaft des nicht reduzierten RTL-Modells (118) behält, wobei sichergestellt wird, dass, die Eigenschaft für das originale RTL hält ⇔ die Eigenschaft für das reduzierte RTL hält,
wobei das RTL-Modell Word-level-Signale enthält, welche Bit-Vektoren umfassen, und das System für jede Bit-Vektorenvariable so arbeiten kann, dass die RTL-Modellweite eines Signals in zwei sequentiellen Schritten reduziert werden kann;
wobei in einem ersten Schritt eine gröbste Granularität jedes Word-level-Signals mittels einer Äquivalenzklassenstruktur bestimmt wird,
um jedes Signal in mehrere benachbarte Stücke aufzuteilen, welche die Bit-Basisgruppen bezüglich struktureller Datenabhängigkeiten angeben, und
in einem zweite Schritt eine minimale Weite bezüglich dynamischer Datenabhängigkeiten ermittelt bestimmt wird,
wobei das System zudem eine Eingangseinheit umfasst, die so arbeiten kann, dass sie Eingangsdaten bezüglich einer Designspezifikation und Eigenschaftsmerkmale eines zu verifizierenden digitalen Schaltungsdesigns empfängt und so arbeiten kann, dass sie eine RTL-Netliste des Designs und der Eigenschaften bereitstellen kann, wobei der Schaltkreis als eine Verbindung von Steuer- und Datenpfadabschnitten definiert werden kann, wobei Signale von einer Weite n so bestimmt werden, dass: $n \in \mathbb{N}_+$ ; und

Bit-Vektoren entsprechender Länge den Signalwert bestimmen.

7. System zur Verifikation eines digitalen Schaltungsdesigns nach Anspruch 6, wobei die Eigenschaftstesteinrichtung so arbeiten kann, dass eine reduzierten RTL-Darstellung empfangen werden kann und eine interne bit-level Darstellung, welche ein Bit für jedes Bit jedes Wort-Signals umfasst, erzeugt werden kann, wobei die Darstellung sequentiell zu einem Verifikationsmodul und dann zu einer Eigenschaftstesteinrichtung geleitet wird, wobei die Eigenschaftstesteinrichtung so arbeiten kann, dass sie ein positives Ergebnis bereitstellen kann, wenn die Schaltkreiseigenschaft gültig bleibt, und welche so arbeitet, dass sie ein Gegenbeispiel bereitstellen kann, wenn die Eigenschaft nicht hält.

8. System zur Verifikation eines digitalen Schaltungsdesigns nach Anspruch 7, wobei eine Signalweitenvergrößerungseinrichtung so arbeiten kann, dass sie ein Gegenbeispiel für reduzierte RTL-Daten empfangen kann und die Signalweite vergrößern kann, um ein Gegenbeispiel für die originale RTL zu erzeugen.

9. System zur Verifikation eines digitalen Schaltungsdesigns nach Anspruch 6, wobei das System so arbeiten kann, dass grobe Granularitäten im Hinblick auf eine Äquivalenzklassenstruktur angeordnet werden können, so das ein anfängliches Erfüllbarkeitsproblem als eine Anzahl von unabhängigen Erfüllbarkeitsproblemen betrachtet werden kann.

**Revendications**

1. Procédé de vérification de conception de circuit numérique implémenté par ordinateur comprenant :

la détermination automatique, pour chaque propriété (112) d'un modèle RTL non réduit (118), d'un modèle RTL réduit (130) avec une largeur de signal réduite pour une spécification de conception, lequel modèle RTL réduit (130) retient la propriété de signal du modèle RTL non réduit, garantissant que: la propriété est valable pour le signal RTL original ⇔ la propriété est valable pour le signal RTL réduit,
dans lequel le modèle RTL comprend des signaux de niveau de mots comprenant des vecteurs de bit, et, pour chaque variable de vecteur bit, le procédé de réduction du modèle RTL est séparé en deux étapes séquentielles ;
la première étape comprenant le calcul de la granularité la plus grossière de chaque signal de niveau de mot au moyen d'une structure de classe d'équivalence, afin de séparer chaque signal en plusieurs unités contiguës qui indiquent les groupes basiques de bits par rapport aux dépendances de données structurelles,
la deuxième étape comprenant le calcul de la largeur minimum par rapport aux dépendances de données dynamiques ; et
la soumission du modèle RTL réduit (130) à un procédé de vérification de propriété, dans lequel, avant la détermination d'un modèle RTL à largeur réduite, la spécification de conception et propriétés d'une conception de circuit numérique sont déterminées ; et,
une liste d'interconnexions RTL des primitives de niveau élevé est synthétisée, par laquelle le circuit est défini comme une interconnexion de partie de chemin de données et de commande, les signaux d'une largeur $n$ étant déterminés de sorte que $n \in N_+$
et les vecteurs bit de longueur respective déterminent la valeur du signal.

2. Procédé de vérification de conception de circuit numérique selon la revendication 1, dans lequel, dans le procédé de vérification de propriété, une représentation de niveau de bit interne contient un niveau de bit variable pour chaque bit de chaque signal de mot, chaque représentation est passée de manière séquentielle à un système de vérification et ensuite à une unité de test de propriété qui opère pour fournir un résultat positif si la propriété des circuits est valable, et qui opère pour fournir un contre-exemple dans le cas où la propriété n'est pas valable.

3. Procédé de vérification de conception de circuit numérique selon la revendication 2, dans lequel, dans le cas où un contre-exemple est produit pour la conception RTL réduite, une mise en valeur de largeur de signal est réalisée pour créer un contre-exemple pour le RTL original.

4. Procédé de vérification de conception de circuit numérique selon la revendication 1, dans lequel, pour chaque variable de vecteur bit, le calcul des granularités grossières est réalisé au moyen d'une structure de classe d'équivalence, par lequel un problème de validabilité initial peut être considéré comme un nombre de problèmes de validabilité indépendants.

5. Procédé de vérification de conception de circuit numérique selon la revendication 4, dans lequel la solution des problèmes de validabilité indépendants peut être déterminée par des fonctions de vecteur-bit de manipulation de bits.

6. Système de vérification de conception de circuit numérique **caractérisé en ce qu'**une unité de vérification de propriété peut fonctionner pour réduire les largeurs des signaux ayant lieu dans un modèle RTL (118) d'une spécification de conception d'entrée pour déterminer un modèle RTL à largeur réduite (130) pour chaque propriété du modèle RTL non réduit, lequel modèle RTL réduit (130) retient la propriété de signal du modèle RTL non réduit, garantissant que: la propriété est valable pour le signal RTL original ⇔ la propriété est valable pour le signal RTL réduite,
dans lequel le modèle RTL comprend des signaux de niveau de mot comprenant des vecteurs-bits et, pour chaque variable de vecteur bit, le système peut fonctionner pour réduire la largeur du modèle RTL d'un signal en deux étapes séquentielles,
dans lequel, une première étape, une granularisation grossière de chaque signal de niveau-de mot est déterminée au moyen d'une structure de classe d'équivalence, afin de séparer chaque signal en plusieurs unités contiguës qui indiquent les groupes de base de bits par rapport aux dépendances de données structurelles et;
dans une deuxième étape, une largeur minimum par rapport aux dépendances de données dynamiques est déterminée ;

dans lequel le système comprend en outre une unité frontale qui peut fonctionner pour recevoir des données d'entrée concernant une spécification de conception et des caractéristiques de propriété d'une conception de circuit numérique à vérifier, et qui peut fonctionner pour fournir une liste d'interconnexions RTL desdites conception et propriété, le circuit pouvant être défini comme une interconnexion de commandes et de parties de chemins de données, dans lequel des signaux d'une largeur $n$ sont déterminés de sorte que : $n \in N_+$; et

des vecteurs bit de longueurs respectives déterminent la valeur du signal.

7. Système de vérification de conception de circuit numérique selon la revendication 6, dans lequel l'unité de vérification de propriété peut fonctionner pour recevoir une représentation RTL réduite, et pour créer une représentation de niveau de bit interne, contenant un bit pour chaque bit de chaque signal de mot, laquelle représentation est passée, de manière séquentielle, à un système de vérification et à une unité de test de propriété, l'unité de test de propriété pouvant fonctionner pour fournir un résultat positif si la propriété de circuit est valable, et qui fonctionne pour fournir un contre-exemple dans le cas où la propriété n'est pas valable.

8. Système de vérification de conception de circuit numérique selon la revendication 7, dans lequel une unité de mise en valeur de largeur de signal peut fonctionner pour recevoir un contre-exemple de données de RTL réduites, et pour élargir la largeur de signal pour fournir un contre-exemple pour le RTL original.

9. Système de vérification de conception de circuits numériques selon la revendication 6,
dans lequel le système peut fonctionner pour arranger des granularités grossières en terme d'une structure de classe d'équivalence, un problème de validabilité initiale pouvant être considérée comme un nombre de problèmes de validabilité indépendants.

**Fig. 1a**

**Fig.1b**

## Fig.2

*Original Signal* $x_{[16]}$
216

*Chunks* : $x_{[16]}[15,12], x_{[16]}[11,6], x_{[16]}[5,5], x_{[16]}[4,2], x_{[16]}[1,0]$
218

*Minimum Widths*: 2 + 1 + 1 + 1 + 2 = 7
220

*Corresponding Reduced Signal* $x'_{[7]}$
222

## Fig.4

EP 1 221 663 B1

## Fig.3

| Bitvector Operator | Syntax | Example |
|---|---|---|
| bitvector variables<br>bitvector constants | $x_{[n]}$<br>$c_{[m]}$ | $x_{[8]}, y_{[1]}, z_{[4]}, \cdots$<br>$10011_{[5]}, 00111111_{[8]}, 0_{[1]}, 1_{[1]}, \cdots$ |
| concatenation | $\otimes$ | $x_{[16]} \otimes y_{[4]}$ |
| extraction | $[j, i]$ | $x_{[8]}[5, 2]$ |
| bitwise negation (inversion) | | $\mathrm{neg}\,(x_{[8]})$ |
| bitwise Boolean operations | and, or, xor<br>nand, nor, xnor | $x_{[12]}$ and $y_{[12]}, x_{[12]}$ or $y_{[12]}, x_{[12]}$ xor $y_{[12]}$<br>$x_{[12]}$ nand $y_{[12]}, x_{[12]}$ nor $y_{[12]}, x_{[12]}$ xnor $y_{[12]}$ |
| if-then-else | ite | $\mathrm{ite}(a_{[4]} = b_{[4]}, x_{[8]}, y_{[8]})$<br>$\mathrm{ite}(a_{[4]} < b_{[4]}, x_{[8]}, y_{[8]})$ |
| arithmetic | $+, -$<br>$*$ | $x_{[32]} + y_{[32]}, x_{[32]} - y_{[32]}$<br>$x_{[16]} * y_{[16]}$ |
| memory read<br>memory write | $mem_{[m \cdot n]}[i_{[l]}]$ | $x_{[10]} := mem_{[128 \cdot 10]}[i_{[7]}]$<br>$mem_{[32 \cdot 8]}[i_{[5]}] := x_{[8]}$ |

EP 1 221 663 B1

slice($y_{[16]}$, 12,8)

$x_{[16]}(7,0)$ — 7 6 5 4 3 2 1 0
$y_{[16]}(7,0)$ — 7 6 5 4 3 2 1 0
$y_{[16]}(15,8)$ — 15 14 13 12 11 10 9 8

$x_{[16]}(7,0)$ — 7 6 5
$x_{[16]}(4,0)$ — 4 3 2 1 0
$y_{[16]}(7,0)$ — 7 6 5 4 3 2 1 0
$y_{[16]}(15,13)$ — 15 14 13
$y_{[16]}(12,8)$ — 12 11 10 9 8

**Fig.5**

bitvectors

$a_{[2]}$ — 1 0

$x_{[8]}$ — 7 6 5 4 3 2 1 0

$y_{[8]}$ — 7 6 5 4 3 2 1 0

$z_{[4]}$ — 3 2 1 0

- - - - - - - - - - - -

$x_{[8]} = y_{[8]}[7,4] \otimes x_{[8]}[3,2] \otimes a_{[2]}$

$= x_{[8]}[7,4]$ and $y_{[8]}[7,4]$

**Dependency Classes of Bitvector Chunks**

$z_{[4]}(3,0)$ — 3 2 1 0
$x_{[8]}(3,2)$ — 3 2
$a_{[2]}(1,0)$ — 1 0
$y_{[8]}(7,4)$ — 7 6 5 4
$x_{[8]}(1,0)$ — 1 0
$x_{[8]}(7,4)$ — 7 6 5 4
$y_{[8]}(3,0)$ — 3 2 1 0

**Granularities**

1 0 — $a_{[2]}(1,0)$

7 6 5 4 | 3 2 | 1 0 — $x_{[8]}(7,4)(3,2)(1,0)$

7 6 5 4 | 3 2 1 0 — $y_{[8]}(7,4)(3,0)$

3 2 1 0 — $z_{[4]}(3,0)$

**Fig.6**

# Fig.6a

| Process 1 | Granularity Analysis of Bitvector Equations |
| --- | --- |

```
gran(e) {
  switch (e);
    case e ≡ 's[n] = t1[m1] ⊗ t2[m2]' :
```
$$\text{gran}('s_{[n]}[n-1, m_2] = t_{1[m_1]}'); \quad \text{gran}('s_{[n]}[m_2-1,0] = t_{2[m_2]}');$$

```
    case e ≡ 's[n] = (t1[m1] ⊗ t2[m2])[j, i]' :
```
$$\textbf{if } (j < m_2) \{$$
$$\quad \text{gran}('s_{[n]} = t_{2[m_2]}[j, i]');$$
$$\} \textbf{ else if } (i \geq m_2) \{$$
$$\quad \text{gran}('s_{[n]} = t_{1[m_1]}[j-m_2, i-m_2]');$$
$$\} \textbf{ else } \{$$
$$\quad \text{gran}('s_{[n]} = t_{1[m_1]}[j-m_2, 0] \otimes t_{2[m_2]}[m_2-1, i]');$$
$$\}$$

```
    case e ≡ 's[n] = (t[m][l,k])[j,i]' :          gran('s[n] = t[m][k + j, k + i]');
    case e ≡ 's[n] = ite(a[m]= b[m], t t[n], te[n])[j,i]' :   gran('s[n] = ite(a[m] = b[m], t t[n][j,i], t e[n][j,i])');
    case e ≡ 's[n] = (t1[m] and t2[m])[j, i]' :   gran('s[n] = t1[m][j,i] and t2[m][j, i]');

    ...

    case e ≡ 's[n] = neg(t[n])' :                 gran('s[n]= t[n]');
    case e ≡ 's[n] = ite(a[m] = b[m], t t[n], t e[n])' :   gran('a[m]= b[m]');  gran('s[n] = t t[n]');  gran('s[n]= t e[n]');
    case e ≡ 's[n] = t1[n] and t2[n]' :           gran('s[n] = t1[n]');  gran('s[n]= t2[n]');

    ...

    case e ≡ 'x[n][j,i] = y[m][l,k]' :            slice(x[n], j,i);  slice(y[m], l,k);  join(x[n]⟨j,i⟩, y[m]⟨l,k⟩);
}
```

EP 1 221 663 B1

## Fig.7

$\varphi(C_1) = 2$

| 1 | 0 |

$C_1$

| 5 | 4 |

| 5 | 4 |

| 7 | 6 |

| 3 | 2 |

| 5 | 4 |

$C_i$

| 15 | 14 | 13 | 12 |

$C_3$

| 3 | 2 | 1 | 0 |

| 1 | 0 |

$\varphi(C_3) = 2$

| 1 |

$C_4$

| 0 |

| 0 |

$\varphi(C_4) = 1$

$C_2$

| 15 | 14 | 13 | 12 | 11 | 10 | 9 | 8 |

| 7 | 6 | 5 | 4 | 3 | 2 | 1 | 0 |

| 7 | 6 | 5 | 4 | 3 | 2 | 1 | 0 |

| 3 | 2 | 1 | 0 |

$\varphi(C_2) = 4$

| 11 | 10 | 9 | 8 |

$C_5$

| 11 | 10 | 9 | 8 |

| 3 | 2 | 1 | 0 |

| 0 |

$\varphi(C_5) = 1$

EP 1 221 663 B1

24

## *Fig. 7a*

| Process 2   Reduced Model Generation |
| --- |

**for** each bitvector variable $x_{[n]}$ {

    $m := 0$ ;

    **for** each chunk $x_{[n]} \langle j, i \rangle$ of the computed granularity of $x_{[n]}$ {

        $C := find\ (\ x_{[n]} \langle j, i \rangle\ )$ ;   // equivalence class containing $x_{[n]} \langle j,i \rangle$

        $m := m + \varphi\,(C)$ ;

    }

    **if** $(m \geq n)$ **then** $m := n$ ;

    replace all occurrences of $x_{[n]}$ in the bitvector equations by $x'_{[m]}$ ;

    and adjust all extraction expressions affected by $x_{[n]}$ ;

}

Fig.8

## Fig.9

| | Property | Original design | Reduced model |
|---|---|---|---|
| Computation times of the prototype for analysis and reduced model generation | nop<br>read<br>write | | 2.96 secs<br>6.53 secs<br>3.24 secs |
| FIFO sizes on RTL | nop<br>read<br>write | 160 cells x 10 bit<br>160 cells x 10 bit<br>160 cells x 10 bit | 160 cells x 2 bit<br>160 cells x 3 bit<br>160 cells x 3 bit |
| Overall number of bits in all relevant signals (cones of influence of the property) | nop<br>read<br>write | 20925<br>31452<br>14622 | 5034  (24.0 %)<br>10592 (33.6 %)<br>5163 (35.3%) |
| Overall number of gates in synthesized netlist | nop<br>read<br>write | 23801<br>23801<br>23801 | 5661  (27.9 %)<br>7929  (33.3 %)<br>7929  (33.3 %) |
| Number of state bits | nop<br>read<br>write | 1658<br>1658<br>1658 | 362  (21.8 %)<br>524  (31.6 %)<br>524  (31.6 %) |
| Property checker runtimes | nop<br>read<br>write_fail<br>write_hold | 23:33 min<br>42:23 min<br>2:08 min<br>27:08 min | 37.96 secs ( 2.7 %)<br>3:27 min ( 8.1 %)<br>25.66 secs (19 .5 %)<br>1:08 min ( 4.2 %) |

EP 1 221 663 B1

Fig. 10

Initialize Granularities for all Variables

Initialize Equivalence Classes

Process (next) Equation

$$x_{[8]} = \text{ite}(a_{[4]} = b_{[4]}, y_{[8]}, z_{[8]})$$

Canonize left and right Term to Compositional Normal Form

$$x_{[8]} = \text{ite}(a_{[4]} = b_{[4]}, y_{[8]}, z_{[8]})$$

Compute coarsest possible Intersection with current Granularities

$$x_{[8]}[7,0] = \text{ite}(a_{[4]}[3,0] =$$
$$b_{[4]}[3,0], y_{[8]}[7,0], z_{[4]}[7,0])$$

Identify mutually related Chunks

$$a_{[4]}[3,0] \longleftrightarrow b_{[4]}[3,0]$$
$$x_{[8]}[7,0] \longleftrightarrow y_{[8]}[7,0]$$
$$x_{[4]}[7,0] \longleftrightarrow z_{[8]}[7,0]$$

YES

Is there another Equation ?

NO

## Fig. 11

Fig. 12

Fig. 13

$$x_{[8]}[7,4] \otimes x_{[8]}[3,0] =$$
$$a_{[4]}[3,0] \otimes b_{[4]}[3,0]$$

Dependencies
not conditioned
by operator

$C$, Dependencies not
conditioned by operator

$min = 1$

Granularity-Analysis

Process (next) Equation

$x_{[8]} = \text{ite}(a_{[4]} = b_{[8]}, z_{[8]})$

Analyze Data-Dependencies
according to the specific Types of Operators
(e.g. If-Then-Else, Arithmetics,
Boolean Operators...)

Possible inequality a ≠ b

*YES*

Is there another
Equation ?

*NO*

Take System of Equivalence Classes
with Dependency Information

Process (next) Equation

C, Dependencies conditional
upon inequality

Compute Minimum Width depending on
Size (Number of Chunks) and Dependencies
(among Chunks of the Class)

$min = C - \text{Dependency}$
component

*YES*

Is there another
Class ?

*NO*

*Fig. 14*

Granularity-Analysis

Process (next) Equation

$a_{[16]}$ and $b_{[16]} = c_{[16]}$ or $d_{[16]}$

Analyze Data-Dependencies
according to the specific Types of Operators
(e.g. If-Then-Else, Arithmetics,
Boolean Operators...)

Boolean-conditioned
dependency
$B(a_{[16]}, b_{[16]}, c_{[16]}, d_{[16]})$

YES

Is there another
Equation ?

NO

Take System of Equivalence Classes
with Dependency Information

Process (next) Equation

$C$, Boolean-conditioned
dependency

Compute Minimum Width depending on
Size (Number of Chunks) and Dependencies
(among Chunks of the Class)

$min = \max(\min(B))$
$B$
$B$ Boolean component
dependency of $C$

YES

Is there another
Class ?

NO

*Fig.15*

Granularity-Analysis

$x_{[8]}\langle 7,4\rangle\langle 3,0\rangle$
$a_{[4]}\langle 3,0\rangle$
$b_{[4]}\langle 3,0\rangle$

Minimum-Width-Abstraction

Go through all initial Equations

Process (next) Equation

$x_{[8]}[7,2]\otimes x_{[8]}[1,0] =$
$(a_{[4]}\otimes b_{[4]}[3,0]\otimes c_{[4]})[11,4]$

Canorize Equation to Normal Form
and go through all Variables occurring
in the Equation

$x_{[8]}[7,4]\otimes x_{[8]}[3,0] =$
$\quad (a_{[4]}[3,0]\otimes b_{[4]}[3,0]$

Process (next) Variable

$x_{[8]}\qquad a_{[4]}\qquad b_{[4]}$

Compute the sum of all Minimum Width of all
Chunks of the Vaiable
according to the computed Granularity
and Equivalence Classes

$\Sigma\text{-}2\qquad \Sigma\text{-}1\qquad \Sigma\text{-}1$

Replace the original Width of the Variable
by the computed Sum
in all Occurrences within the Equation

$x_{[2]}[1,1]\otimes x_{[2]}[0,0] =$
$\quad a_{[1]}[0,0]\otimes b_{[1]}[0,0]$

YES ◄ Is there another Variable ?

NO

YES ◄ Is there another Equation ?

NO

*Fig. 16*

$$x_{[8]} \langle 7,6 \rangle \langle 5,0 \rangle$$
$$y_{[8]} \langle 7,6 \rangle \langle 5,0 \rangle$$
$$x_{[8]} \langle 7,4 \rangle \langle 3,0 \rangle$$
$$a_{[4]} \langle 3,0 \rangle$$
$$b_{[4]} \langle 3,0 \rangle$$

```
        Granularity-Analysis

      Minimum-Width-Abstraction

     Go through all initial Equations

        Process (next) Equation

   Canorize Equation to Normal Form
   and go through all Variables occurring
          in the Equation

         Process (next) Variable

   Compute the sum of all Minimum Width of all
          Chunks of the Vaiable
      according to the computed Granularity
         and Equivalence Classes

   Replace the original Width of the Variable
          by the computed Sum
     in all Occurrences within the Equation

   YES        Is there another
                Variable ?

               NO

   YES        Is there another
              Equation ?

               NO
```

$$x_{[8]} = \text{ite}(a_{[4]} = b_{[4]}, \ y_{[8]}, \ z_{[8]})$$

$$x_{[8]} \quad y_{[4]} \quad z_{[8]} \quad a_{[4]} \quad b_{[4]}$$

$$\Sigma\text{- }3 \qquad \Sigma = 3 \qquad \Sigma = 3$$
$$\Sigma = 1 \qquad \Sigma = 1$$

$$x_{[3]} = \text{ite}(a_{[1]} = b_{[1]}, \ y_{[3]}, \ z_{[3]}$$

**Fig.17**

$a_{[16]} \langle 15,8 \rangle \langle 7,2 \rangle \langle 1,0 \rangle$
$b_{[16]} \langle 15,8 \rangle \langle 7,2 \rangle \langle 1,0 \rangle$
$c_{[16]} \langle 15,8 \rangle \langle 7,2 \rangle \langle 1,0 \rangle$
$d_{[16]} \langle 15,8 \rangle \langle 7,2 \rangle \langle 1,0 \rangle$

```
            │
    ┌───────▼────────────────┐
    │  Granularity-Analysis  │
    └───────┬────────────────┘
    ┌───────▼────────────────┐
    │ Minimum-Width-Abstraction │
    └───────┬────────────────┘
    ┌───────▼────────────────┐
    │ Go through all initial Equations │
    └───────┬────────────────┘
    ┌───────▼────────────────┐
    │  Process (next) Equation │
    └───────┬────────────────┘
```

$a_{[16]}$ and $b_{[16]} = c_{[16]}$ or $d_{[16]}$

```
    ┌───────▼────────────────┐
    │ Canorize Equation to Normal Form │
    │ and go through all Variables occurring │
    │        in the Equation │
    └───────┬────────────────┘
    ┌───────▼────────────────┐
    │  Process (next) Variable │
    └───────┬────────────────┘
```

$a_{[16]} \qquad b_{[16]} \qquad c_{[16]} \qquad d_{[16]}$

```
    ┌───────▼────────────────┐
    │ Compute the sum of all Minimum Width of all │
    │        Chunks of the Vaiable │
    │ according to the computed Granularity │
    │        and Equivalence Classes │
    └───────┬────────────────┘
```

$\Sigma$- 4 $\quad \Sigma = 4 \quad \Sigma = 3 \quad \Sigma = 4$

```
    ┌───────▼────────────────┐
    │ Replace the original Width of the Variable │
    │        by the computed Sum │
    │ in all Occurrences within the Equation │
    └───────┬────────────────┘
```

$a_{[4]}$ and $b_{[4]} = c_{[4]}$ or $d_{[4]}$

```
  YES ◄─── < Is there another Variable ? >
                    │ NO
  YES ◄─── < Is there another Equation ? >
                    │ NO
```

**Fig. 18**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5946481 A
- US 59464811 B
- US 5465216 A
- US 5926622 A

**Non-patent literature cited in the description**

- An efficient decision procedure for the theory of fixed sized bit-vectors. *CAV-97,* 1997, 60-71